(19) Europäisches Patentamt
European Patent Office
Office européen des brevets

(11) Publication number: **0 208 470 B1**

(12) **EUROPEAN PATENT SPECIFICATION**

(45) Date of publication of patent specification: **10.04.91**

(51) Int. Cl.5: **H03J 5/02**, H03J 7/18, H03J 3/06

(21) Application number: **86304933.4**

(22) Date of filing: **25.06.86**

# (54) Signal receiver with tuning circuits.

(30) Priority: **02.07.85 JP 145505/85**
**02.07.85 JP 145513/85**

(43) Date of publication of application:
**14.01.87 Bulletin 87/03**

(45) Publication of the grant of the patent:
**10.04.91 Bulletin 91/15**

(84) Designated Contracting States:
**DE FR GB**

(56) References cited:
**WO-A-84/02236**
**DE-A- 2 856 397**

**ELEKTRONIK, vol. 33, no. 9, 4th May 1984, pages 23-24, Munich, DE; M. ENGLMEIER: "Mup gleicht TV-Tuner ab"**

**ICCE 85, Session V - TV Signal Processing II, DIGEST OF TECHN. PAPERS, June 1985, pp. 78 and 79, D. DUMONT et al**

(73) Proprietor: **MATSUSHITA ELECTRIC INDUSTRIAL CO., LTD.**
**1006, Oaza Kadoma**
**Kadoma-shi, Osaka-fu, 571(JP)**

(72) Inventor: **Sakashita, Seiji**
**1-B40-405, Otokoyamaishishiro**
**Yawata-shi Kyoto-fu, 614(JP)**
Inventor: **Fukui, Kiyotake**
**15-2, Higashisyoujaku**
**Settsu-shi Osaka-fu(JP)**

(74) Representative: **Crawford, Andrew Birkby et al**
**A.A. THORNTON & CO. Northumberland House 303-306 High Holborn**
**London WC1V 7LE(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services

**EP 0 208 470 B1**

## Description

1. Field of the Invention

The present invention relates to a signal receiver which is significantly effective for use with a tuner.

2. Prior Arts and Problems

Any conventional signal receivers, in particular, the signal receiver which is provided with tuning circuits using varactor diodes feeds identical voltage to respective tuning circuits, and thus, due to different capacitances between varactor diodes, there is a considerable difference between frequency characteristics of respective tuning circuits. To compensate for this, one of the prior arts had proposed a specific constitution related to the independent control over respective tuning circuits for maximizing output of intermediate frequencies by feeding tuning voltages to individual varactor diodes in order that tuning circuits can be provided with the best frequency characteristics. This art is expressly disclosed by the Japanese Patent Publication No. 58-18008 and presented by the technical publication "COMPUTER CONTROLLED TELEVISION CHANNEL SELECTION AND TUNER ALIGNMENT", written by Daniel Dumont and Arno Neelen; IEEE ICCE85 SESSION V - TV SIGNAL PROCESSING II, DIGEST OF TECHNICAL PAPERS, JUNE, 1985, Respectively.

However, the circuit constitution proposed by this prior art causes output of intermediate frequencies to be controlled only in the maximizing direction and seeks maximum power within the output signal bands. Consequently, there is no room for identifying whether frequency characteristics of respective tuning circuits exactly match ideal characteristics within the output signal bands, or not. Although the proposed art improves power gain and signal-to-noise (S/N) ratio, signals may distort themselves due to inclined frequency characteristics within the output signal bands.

The disclosure of WO-A-84/02236 also provides a signal receiver in which optimization of the frequency characteristic of the receiver is performed. In this arrangement, when a desired reception channel is selected, the tuner oscillator is switched off, while another oscillator simulating reception signals is activated, on at least two frequencies within the desired reception channel. A demodulator and microprocessor are adapted to adjust the several tuning elements in the receiver to optimize the tuning.

The present invention provides a signal receiver apparatus comprising:

a receiver part for converting a radio frequency signal to an intermediate frequency signal, comprising at least one tuning circuit for tuning a frequency of said radio frequency signal, a radio frequency amplifier for amplifying said radio frequency signal, a local oscillator for generating a local oscillation signal, and a mixer for mixing the frequency-tuned radio frequency signal and said local oscillation signal to obtain said intermediate frequency signal;

demodulating means for demodulating said intermediate frequency signal;

reference signal generating means for generating a reference signal;

means for applying said reference signal to said receiver part as said radio frequency signal;

voltage delivery means for delivering voltages to said tuning circuit to change a frequency characteristic of said receiver part;

detecting means for detecting levels of a frequency signal derived from said receiver part corresponding to a plurality of frequencies within a predetermined frequency range to obtain a frequency characteristic of said receiver part; and

control means for converting said voltages supplied by said voltage delivery means and said levels into binary-coded signals which are stored in memory and for performing a frequency characteristic adjusting operation of said apparatus by controlling said reference signal generating means and said local oscillator to sweep a frequency of a signal to be processed in said receiver part within said predetermined frequency range so that the frequency characteristic of said receiver part appears as a response of said frequency signal derived from said receiver part of the frequency-swept signal, comparing the frequency characteristic of said receiver part obtained by said detecting means with a desired frequency characteristic to obtain an error therebetween, and controlling said voltage delivery means to change the frequency characteristic of said receiver part to reduce said error until said error is substantially eliminated,

characterised in that said detecting means detects levels of said intermediate frequency signal corresponding to a plurality of frequencies within said predetermined frequency range to obtain the frequency characteristic of said receiver part,

that said control means controls said reference signal generating means and said local oscillator through said voltage delivery means to sweep the frequency of one of said reference signal and said local oscillation signal within said predetermined frequency range and maintain constant the frequency of the other of said reference signal and said local oscillation signal, and that said apparatus further comprises AGC voltage holding means for holding an AGC voltage obtained at said demodulating means when a selected channel signal is received and applying the held AGC voltage signal to said radio frequency amplifier to fix a gain of said radio frequency amplifier and to said reference signal generating means to fix a level of said reference signal at substantially the same level as said selected channel signal during the frequency characteristic adjusting operation.

An advantage of the present invention is that it provides a novel signal receiver which first detects variation of frequency characteristic of the signal receiver within receivable signal bands caused by gain control and variation of said frequency characteristics between channels by applying a plurality of frequencies, followed by control of frequency characteristics so that the best characteristics can be generated, while the signal receiver reflecting the present invention dispenses with severe suppression of error of tuning elements and features significantly improved performance characteristics and productivity as well.

By realising the system constitution mentioned above, the signal receiver reflecting the present invention can securely achieve the aimed frequency characteristics, and as a result, frequency characteristics of signals within receivable bands can be improved significantly. In addition, said signal receiver can effectively eliminate deterioration of frequency characteristics within receivable bands caused by error of tuning elements, variation of frequency characteristics while controlling gains, and chanel-to-channel error. Thus, the present invention provides an extremely useful signal receiver featuring the significantly improved performance characteristics and productivity.

BRIEF DESCRIPTION OF THE DRAWINGS

The present invention will be better understood from the detailed description given herein below and the accompanying drawings which are given by way of illustration only, and thus are not limitative of the present invention wherein:

FIG. 1 is a simplified block diagram of the circuit making up the signal receiver using reference signals generated by oscillation of oscillator within the desired channel band reflecting the first preferred embodiment of the present invention;

FIG. 2 is a simplified block diagram of the circuit making up the signal receiver which uses reference signals comprised of signals generated within the desired channel bands by applying the integration of signals oscillated by the primary and local oscillators reflecting the second preferred embodiment of the present invention;

FIG. 3 is a flowchart related to the sequential operations of the signal receiver in conjunction with the first preferred embodiment of the present invention;

FIG. 4 is a chart denoting the basis of identifying frequency characteristics of the signal receiver related to the first preferred embodiment of the present invention;

FIG. 5 is a schematic circuit diagram related to means for generating sweep signals comprised of the primary oscillator and signal-level controller circuit reflecting another preferred embodiment;

FIG. 6 is a schematic diagram of the circuit comprised of means for generating sweep signals, primary oscillator, and the signal-level controller type mixer reflecting a still another preferred embodiment;

FIG. 7 is a schematic diagram of the signal-level controller circuit of sweep-signal generating means, which is comprised of two units of diodes, reflecting a still further preferred embodiment;

FIG. 8 is a schematic diagram of the signal-level controller circuit of sweep-signal generating means, which is comprised of two units of transistors, reflecting a still further preferred embodiment;

FIG. 9 is a schematic diagram of the signal-level controller type of sweep-signal generating means, which is comprised of four units of transistors, reflecting a still further preferred embodiment;

FIG. 10 is a schematic diagram of the signal-level controller type mixer of sweep-signal generating means, which is comprised of four units of transistors, reflecting a still further preferred embodiment;

FIG. 11 is a schematic diagram of the signal-level controller type mixer of sweeping means, which is comprised of three units of transistors and a piece of diode, reflecting a still further preferred embodiment;

FIG. 12 is a chart denoting the relationship of frequencies of a variety of signals when the primary oscillator oscillates itself within the desired channel bands in conjunction with the first preferred embodiment;

FIG. l3 is a chart denoting the relationship of frequencies of respective signals when the primary oscillator oscillates within the desired channel bands related to another preferred embodiment derived from the first preferred embodiment;

FIG. l4 is a chart denoting the relationship of frequencies of respective signals when the primary oscillator oscillates within intermediate frequency bands and frequency oscillated by the local oscillator is stationary reflecting the second preferred embodiment;

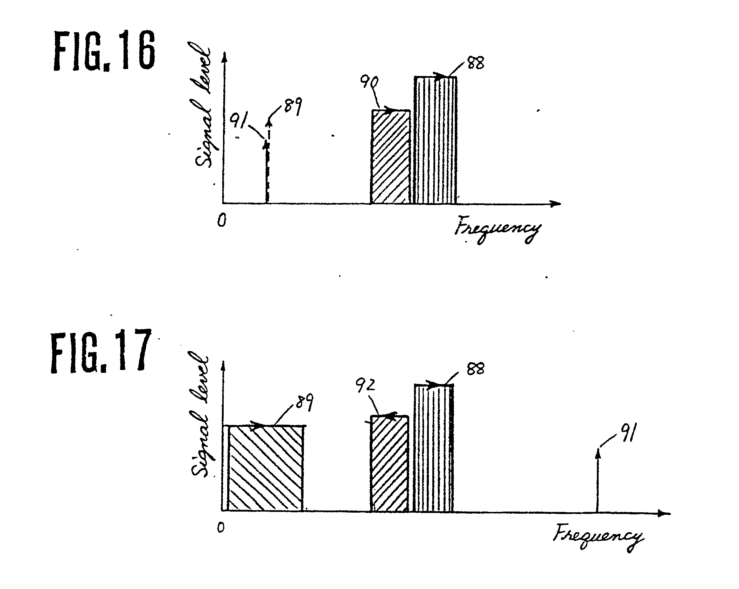

FIG. 15 is a chart denoting the relationship of frequencies of respective signals when the primary oscillator oscillates within a specific band corresponding to the sum of frequency oscillated by local oscillator and the desired channel reflecting another preferred embodiment derived from the second preferred embodiment;

FIG. 16 is a chart denoting the relationship of frequencies of respective signals when the primary oscillator oscillates within the intermediate frequency band and frequency oscillated by local oscillator executes sweeping operation reflecting still another preferred embodiment derived from the second preferred embodiment;

FIG. 17 is a chart denoting the relationship of frequencies of respective signals when the primary oscillator oscillates within a specific band corresponding to the sum of frequencies oscillated by local oscillator and the desired channel and frequency oscillated by said local oscillator executes sweeping operation reflecting still further embodiment derived from the second preferred embodiment;

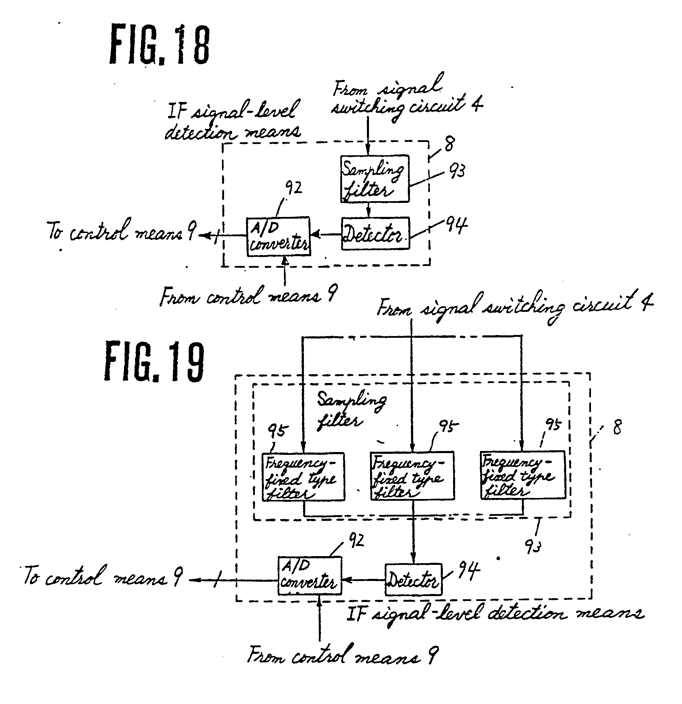

FIG. 18 is a schematic block diagram of the circuit of another preferred embodiment, in which means for detecting signal level of intermediate frequency is comprised of sampling filter, detector, and the A/D converter;

FIG. 19 is a schematic block diagram of the circuit of still another preferred embodiment, in which sampling filter of means for detecting signal level of intermediate frequency is comprised of frequency-fixing filters which are connected to each other in parallel;

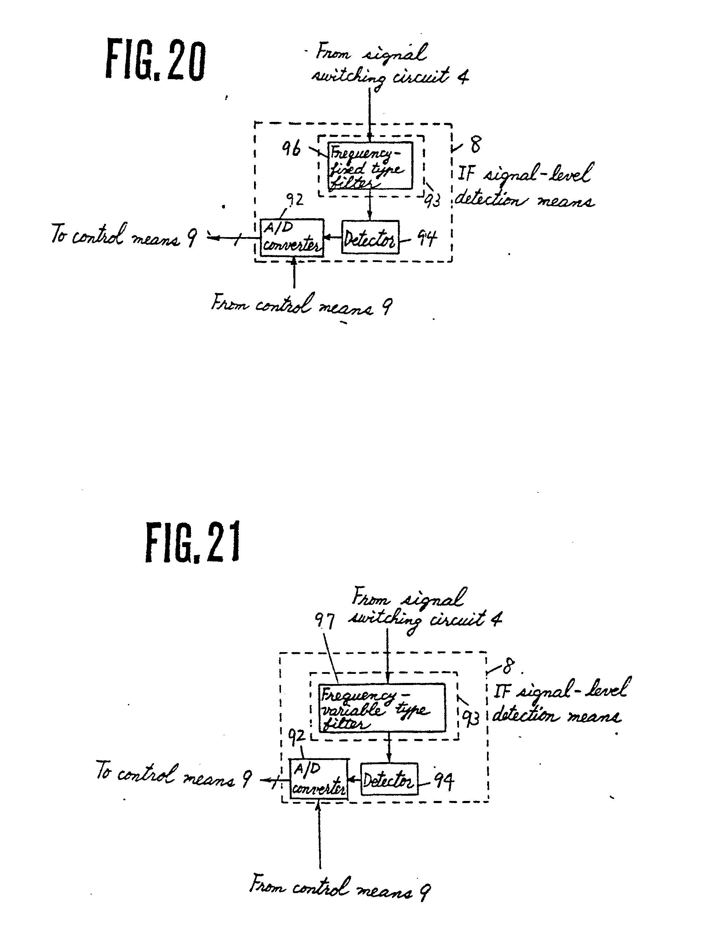

FIG. 20 is a schematic block diagram of the circuit of still another preferred embodiment, in which sampling filter of means for detecting signal level of intermediate frequency is comprised of a frequency-fixing filter;

FIG. 21 is a schematic block diagram of the circuit of a still further preferred embodiment, in which sampling filter of means for detecting signal level of intermediate frequency is comprised of frequency-variable filter;

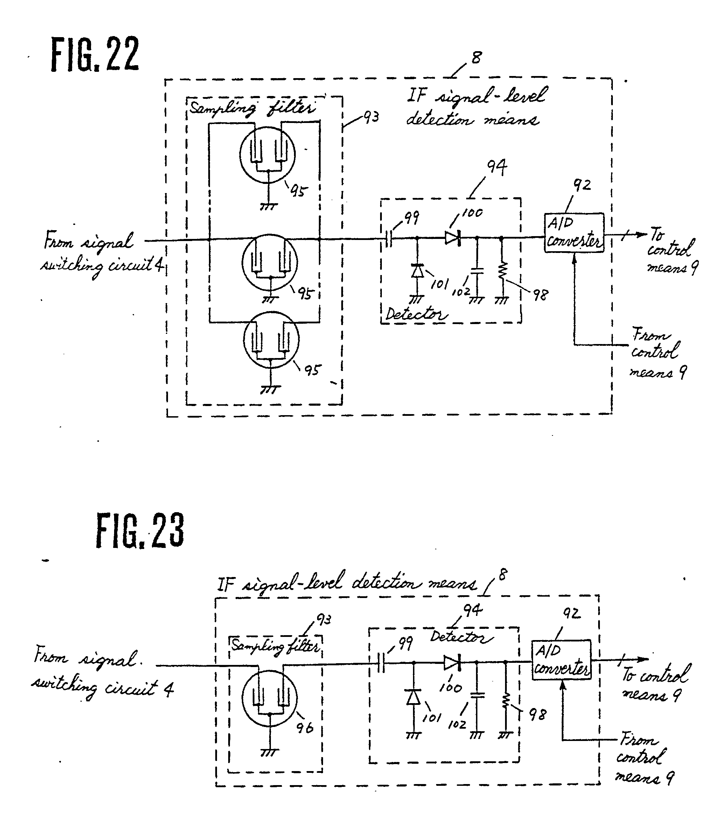

FIG. 22 is a schematic block diagram of the circuit of one of the preferred embodiments, in which sampling filter of means for detecting signal level of intermediate frequency is comprised of a plurality of saw-toothed filters;

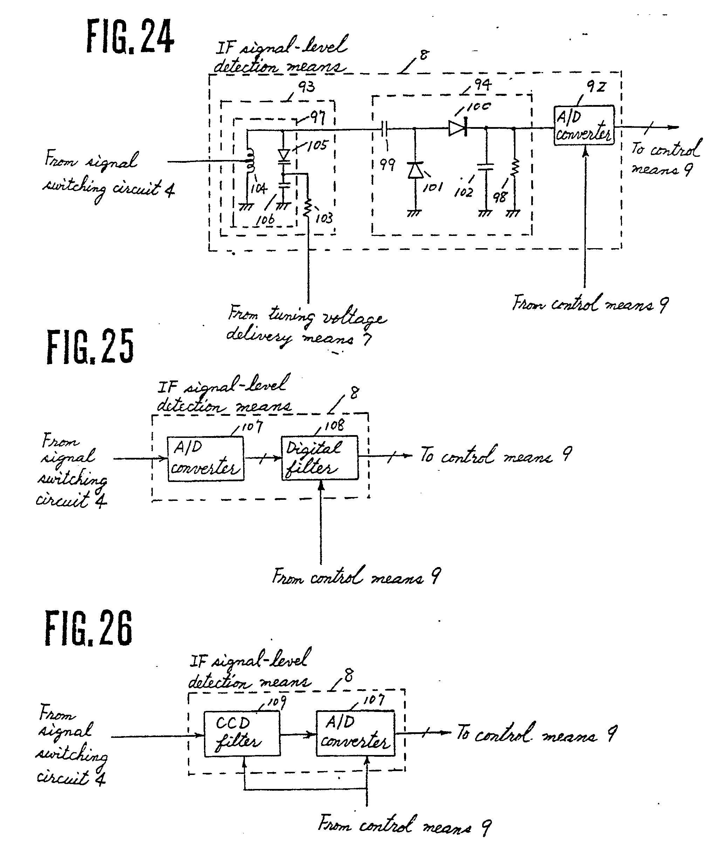

FIG. 23 is a schematic block diagram of the circuit of another preferred embodiment, in which sampling filter of means for detecting signal level of intermediate frequency is comprised of a saw-toothed filter;

FIG. 24 is a schematic block diagram of the circuit of a still further preferred embodiment, in which sampling filter of means for detecting signal level of intermediate frequency is comprised of windings and varactor diodes;

FIG. 25 is a schematic block diagram of the circuit of one of the preferred embodiments, in which means for detecting signal level of intermediate frequency is comprised of an A/D converter and a digital filter;

FIG. 26 is a schematic block diagram of the circuit of a still further preferred embodiment, in which means for detecting signal level of intermediate frequency is comprised of a CCD filter and an A/D converter;

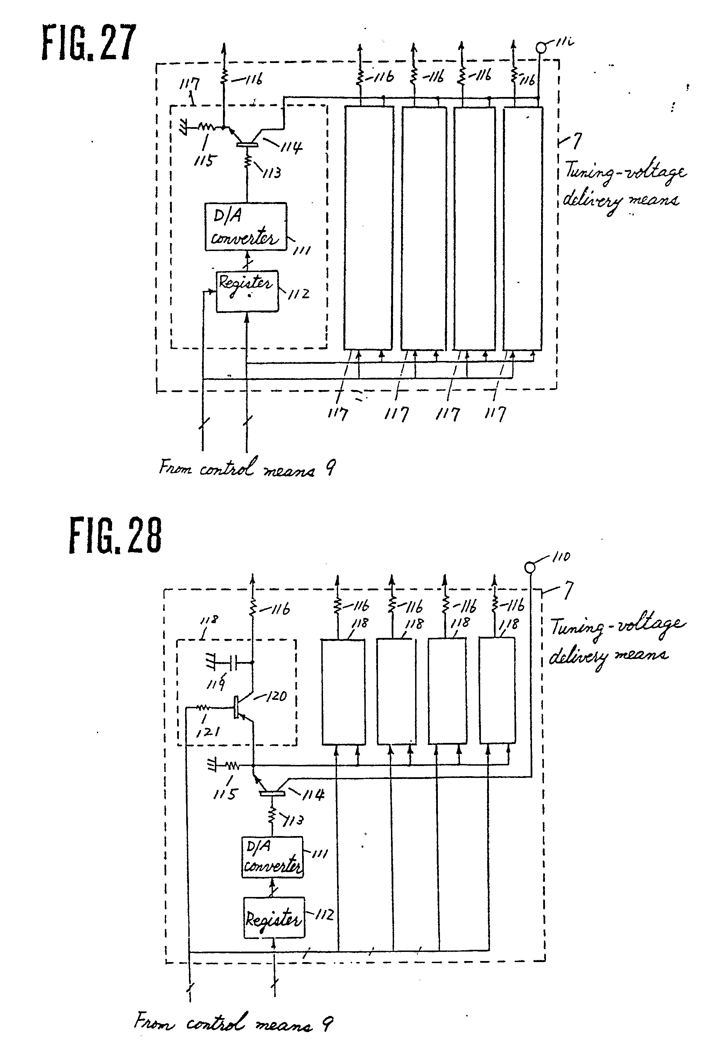

FIG. 27 is a schematic block diagram of the circuit of one of the preferred embodiments, in which D/A converters of tuning voltage supply means are connected to each other in parallel by the number identical to that of tuning circuit;

FIG. 28 is a schematic block diagram of the circuit of one of the preferred embodiments, which is comprised of one unit of D/A converter;

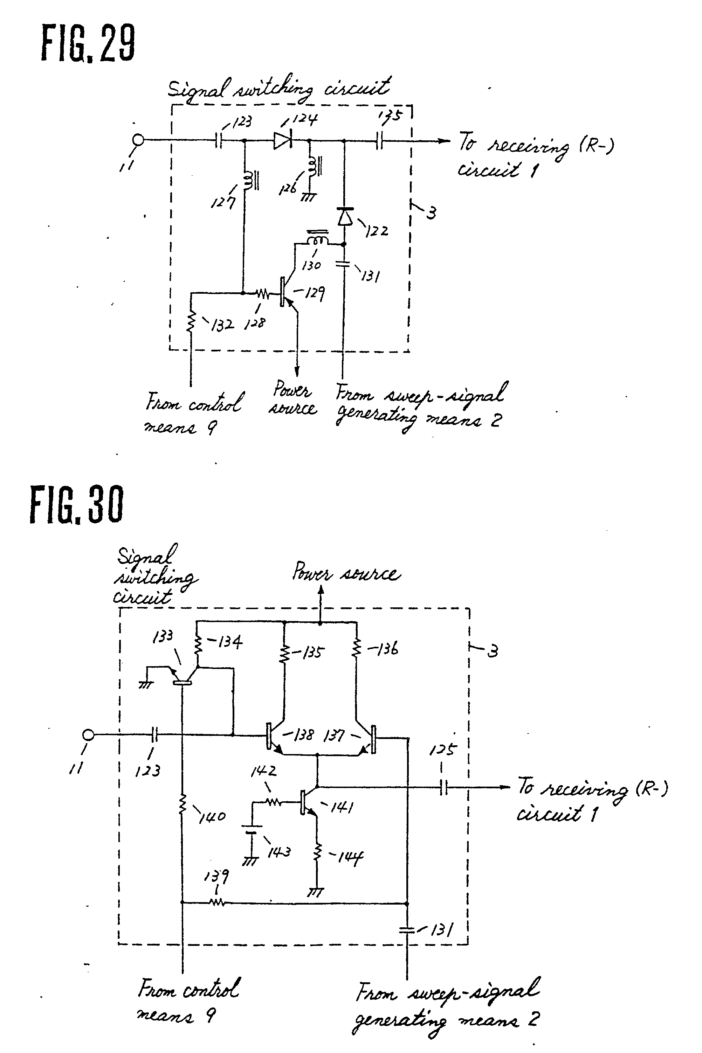

FIG. 29 is a schematic block diagram of the circuit of one of the preferred embodiments, in which the first signal switching circuit is comprised of two pieces of diodes.

FIG. 30 is a schematic block diagram of the circuit of one of the preferred embodiments, in which the first signal switching circuit is comprised of four pieces of transistors;

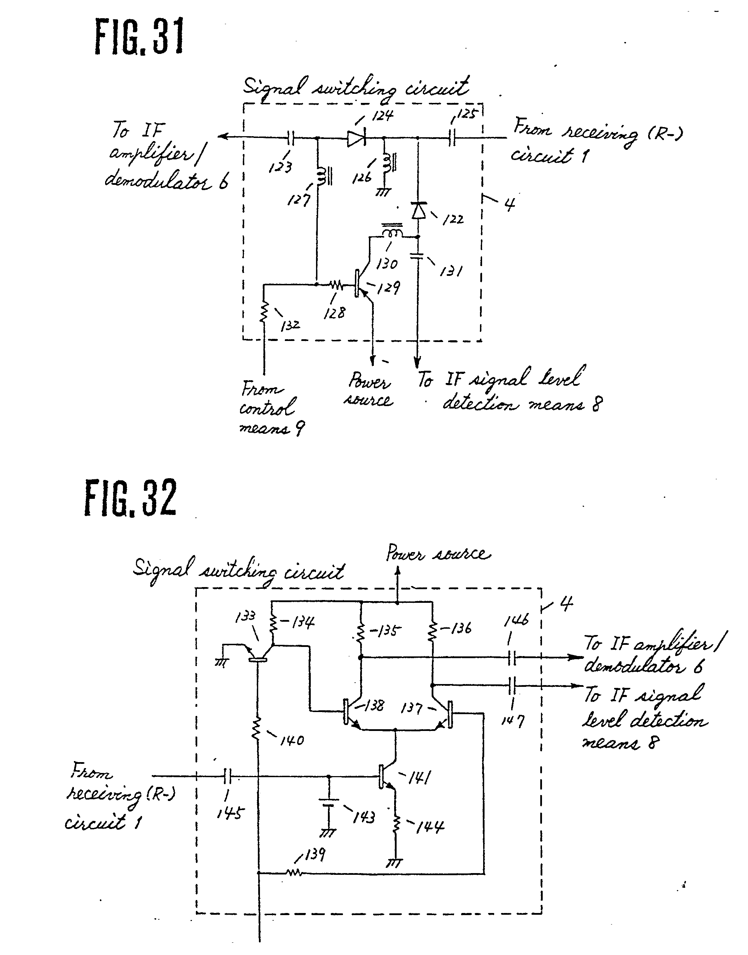

FIG. 31 is a schematic block diagram of the circuit of one of the preferred embodiments, in which the second signal switching circuit is comprised of two pieces of diodes;

FIG. 32 is a schematic block diagram of the circuit of one of the preferred embodiments, in which the second signal switching circuit is comprised of four pieces of transistors;

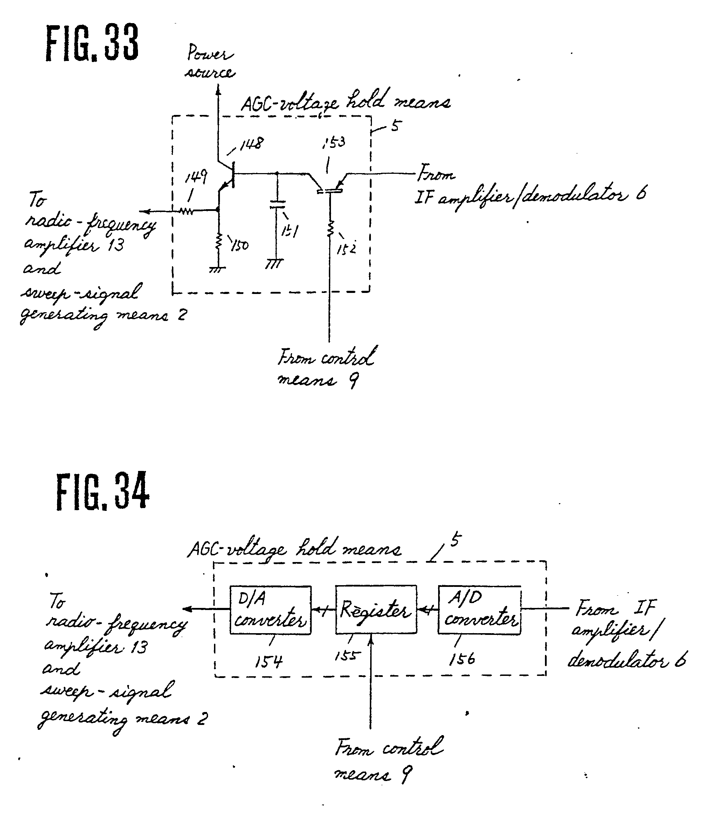

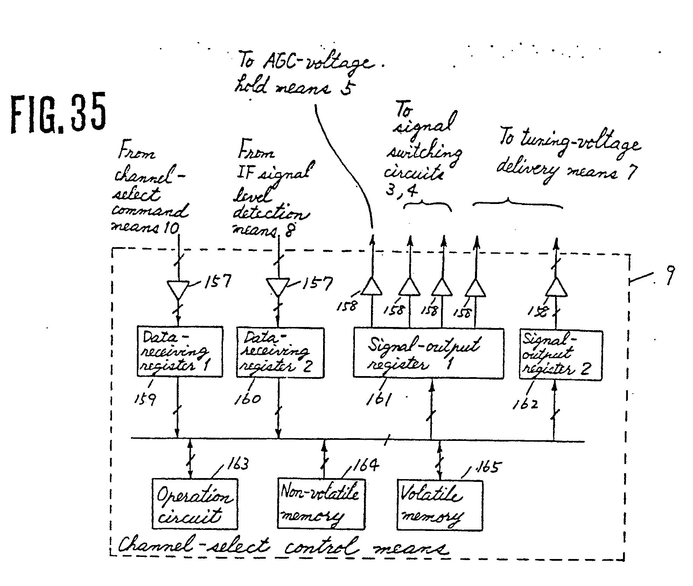

FIG. 33 is a schematic block diagram of the circuit of one of the preferred embodiments, in which AGC voltage retention means is comprised of two pieces of transistors and a capacitor;

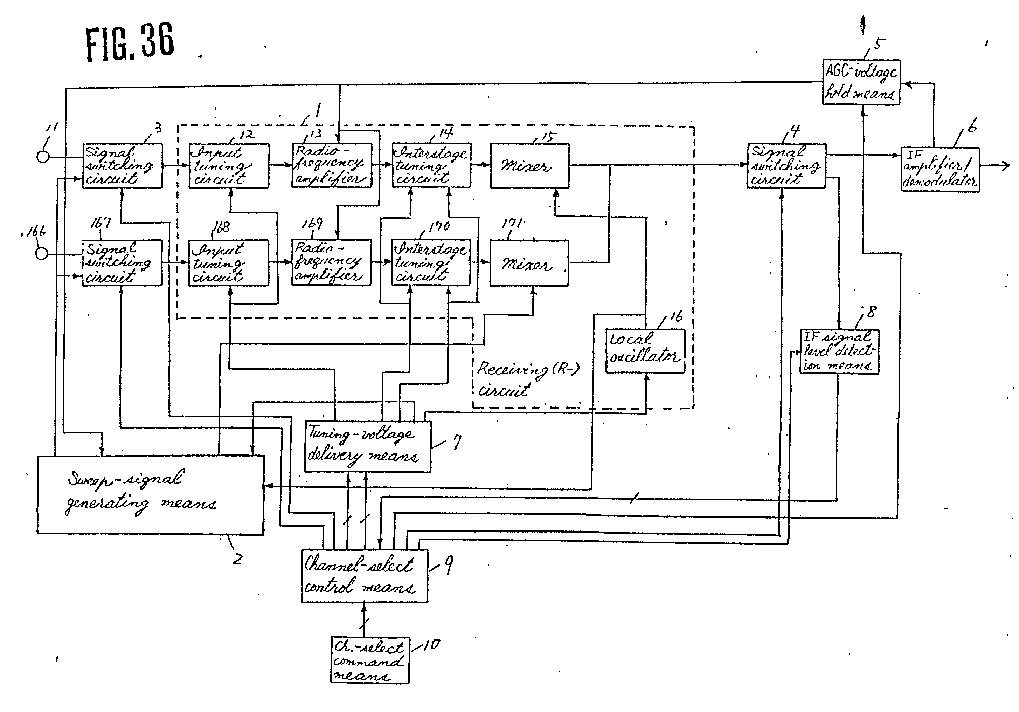

FIG. 34 is a schematic block diagram of the circuit of one of the preferred embodiments, in which AGC voltage retention means is comprised of a D/A converter, a resistor and an A/D converter;

FIG. 35 is a simplified block diagram of the circuit making up control means; and

FIG. 36 is a simplified block diagram of the circuit of one of the preferred embodiments, in which the primary oscillator is made available for another local oscillator.

## DESCRIPTION OF THE PREFERRED EMBODIMENTS

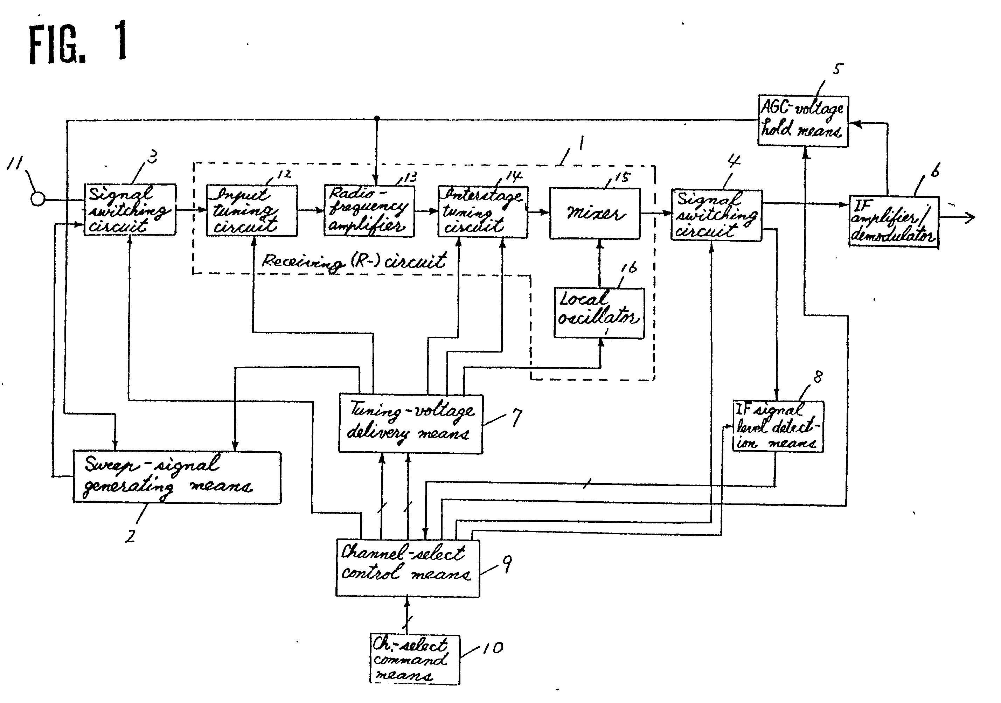

Referring now to the accompanying drawings, the first preferred embodiment of the present invention is described below. In FIG. 1, using frequency conversion means, receiving circuit 1 (R-circuit, hereinafter) converts signal of the desired channel into a specific intermediate frequency. Said R-circuit 1 is comprised of input tuning circuit 12, radio-frequency (RF) amplifier 13, interstage tuning circuit 14, mixer 15 and local oscillator 16, respectively. signal of the desired channel band is delivered to radio-frequency amplifier 13 via input tuning circuit 12, where said radio-frequency amplifier 13 allows the gain of signal to vary in proportion to the AGC voltage. The amplified signal is then delivered to interstage tuning circuit 14 which eliminates signal of the image-band, and then mixer 15 mixes said signal with the signal oscillated by local oscillator 16, and as a result, intermediate frequency signal is generated from the output terminal of mixer 15. Since double tuning circuit is often made available for said interstage tuning circuit, at least two systems of the tuning voltage are necessary.

By activating channel-select command means 10 and channel-select control means 9, desired channel is selected by feeding the identical tuning voltages to input tuning circuit 12, interstage tuning circuit 14, and local oscillator 16 before eventually receiving signals from the selected channel. The desired channel signal is received from terminal 11, and then signal switching circuit 3 functions so that control means 9 can deliver signal from R-circuit 1 to the following input tuning circuit 12 of R-circuit 1. R-circuit 1 then converts the received signal into intermediate frequency signal, which is then delivered to signal switching circuit 4. Signal switching circuit 4 functions to allow control means 9 to deliver signal from R-circuit 1 to the following intermediate frequency (IF) amplifier/demodulator 6. Intermediate frequency signal which passed through signal switching circuit 4 is then amplified and detected by intermediate frequency amplifier/demodulator 6 before being delivered to the following signal processing circuit. Intermediate frequency amplifier/demodulator 6 generated AGC voltage for delivery to AGC-voltage hold means 5, which then delivers this voltage to radio-frequency amplifier 13 and sweep signal generator 2.

AGC-voltage hold means 5 holds AGC voltage corresponding to the desired channel signal level for a specific duration, and then control means 9 delivers control signal to signal switching circuit 3, where signal from said sweep signal generating means 2 is subjected to switching before being sent to input tuning circuit 12 of R-circuit 1, and finally reference signal of the desired channel band generated by said sweep signal generating means 2 is delivered to R-circuit 1. Simultaneously, reference signal having a specific level corresponding to the AGC voltage from AGC voltage hold means 5 is also supplied to R-circuit 1. After being delivered to R-circuit 1, the reference signal is then subjected to frequency-conversion before being delivered to signal switching circuit 4. Signal switching circuit 4 is then switched by control means 9 so that intermediate frequency signal can be led to intermediate-frequency signal level detection means 8, which then converts intermediate frequency signal into DC signal corresponding to the detected signal level. The DC signal is then binary-coded before being delivered to control means 9. Using the binary-coded DC-level signal, control means 9 computes the signal level of a plurality of frequencies present in R-circuit 1 for detecting frequency characteristics, and then it causes the tuning voltages of input tuning circuit 12 and interstage tuning circuit 14 to slightly vary themselves in the direction of reducing difference from the aimed frequency characteristics, and finally, it outputs the varied tuning voltage through tuning-voltage delivery means 7. If these frequency characteristics in R-circuit 1 were still different from the aimed frequency characteristics, control means 9 causes tuning voltage to vary themselves furthermore until all the frequency characteristics eventually match each other. When these frequency characteristics exactly match the aimed one, control means 9 stores respective tuning voltages in memory, and then it causes signal switching circuits 3 and 4 to be switched in the direction of receiving the desired channel signal. On the other hand, AGC-voltage hold means 5 discontinues retention of AGC voltage and directly delivers it to radio-frequency amplifier 13 and sweep-signal generating means 2 without holding AGC voltage from intermediate-frequency amplifier/demodulator 6 and maintains this state until starting to select the desired channel again.

According to the first preferred embodiment of the present invention, since the system retains a specific AGC voltage corresponding to the field intensity while receiving the desired-channel signal and compares the level deviations between a plurality of frequencies, compared to the conventional provision of tuning voltages for merely seeking the maximum point of intermediate-frequency signal level, the signal receiver reflecting the first preferred embodiment of the present invention not only correctly receives the desired-channel signals using the significantly improved performance characteristics, but it also securely suppresses error generated by the tuning circuit even when respective tuning elements function with erroneous components.

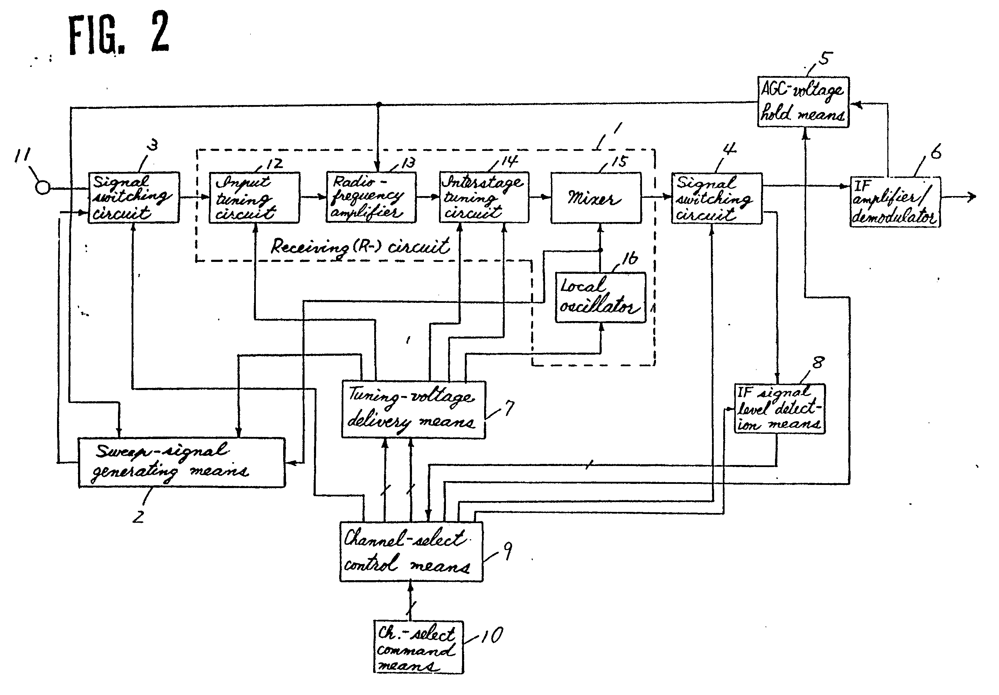

Next, referring to the accompanying drawings, the second preferred embodiment of the present invention is described below. In FIG. 2, R-circuit 1 converts the desired-channel signal into a specific intermediate frequency by applying frequency-conversion means. R-circuit 1 is comprised of input tuning circuit 12, radio-frequency amplifier 13, interstage tuning circuit 14, mixer 15, and local oscillator 16, respectively. Signal of the desired channel band is delivered to radio-frequency amplifier 13 via input tuning circuit 12. After amplification, interstage tuning circuit 14 eliminates signals present in the image-band, while genuine signal components are then mixed together with oscillated signal from local oscillator 16 by means of mixer 15, which then outputs a specific intermediate frequency signal. Since double tuning circuits are often made available for the interstage tuning circuit, at least two systems of tuning voltages are necessary.

By activating channel-select command means 10 and channel-select control means 9, desired channel is selected by feeding the identical tuning voltages to input tuning circuit 12, interstage tuning circuit 14, and local oscillator 16 before eventually receiving signals from the selected channel. The desired channel signal is received from terminal 11, and then signal switching circuit functions so that control means 9 can deliver signal from R-circuit 1 to the following input tuning circuit 12 of R-circuit 1. Receiver 1 then converts the received signal into intermediate frequency signal, which is then delivered to signal switching circuit 4. Signal switching circuit 4 functions to allow control means 9 to deliver signal from R-circuit 1 to the following intermediate frequency amplifier/demodulator 6. Intermediate frequency signal which passed through signal switching circuit 4 is then amplified and detected by intermediate frequency amplifier/demodulator 6 before being delivered to the following signal processing circuit. Intermediate frequency amplifier/demodulator 6 generates AGC voltage for delivery to radio-frequency amplifier 13 and sweep signal generator 2.

AGC-voltage hold means 5 holds AGC voltage corresponding to the desired channel signal level for a specific duration, and then control means 9 delivers control signal to signal switching circuit 3, where signal from said sweep signal generating means 2 is subjected to switching before being sent to input tuning circuit 12 of R-circuit 1, and finally reference signal of the desired channel band generated by said sweep signal generating means 2 is delivered to R-circuit 1, where reference signal of the desired channel band is generated by applying part of oscillated signal from local oscillator and differential frequency from the primary oscillator of sweep signal generating means 2 of R-circuit 1. Simultaneously, reference signal having a specific level corresponding to the AGC voltage from AGC-voltage hold means 5 is also supplied to R-circuit 1. After being delivered to R- circuit 1, the reference signal is then subjected to frequency-conversion before being delivered to signal switching circuit 4. Signal switching circuit 4 is then switched by control means 9 so that intermediate frequency signal can be led to intermediate-frequency signal level detection means 8, which then converts intermediate frequency signal into DC signal corresponding to the detected signal level. The DC signal is then binary-coded before being delivered to control means 9. Using the binary-coded DC-level signal, control means 9 computes the signal level of a plurality of frequencies present in R-circuit 1 for detecting frequency characteristics, and then it causes the tuning voltages of input tuning circuit 12 and interstage tuning circuit 14 to slightly vary themselves in the direction of reducing difference from the aimed frequency characteristics, and finally, it outputs the varied tuning voltage through tuning-voltage delivery means 7. If these frequency characteristics in R-circuit 1 were still different from the aimed frequency characteristics, control means 9 causes tuning voltage to vary themselves furthermore until all the frequency characteristics eventually match each other. When these frequency characteristics exactly match the aimed one, control means 9 stores respective voltage values in memory, and then it causes signal switching circuits 3 and 4 to be switched in the direction of receiving the desired channel signal. On the other hand, AGC-voltage hold means 5 discontinues retention of AGC voltage and directly delivers it to radio-frequency amplifier 13 and sweep-signal generating means 2 without holding AGC voltage from intermediate-frequency amplifier/demodulator 6 and maintains this state until starting to select the desired channel again.

According to the second preferred embodiment of the present invention, since the system retains a specific AGC voltage corresponding to the field intensity while receiving the desired-channel signal and compares the level deviation between a plurality of frequencies, compared to the conventional provision of tuning voltages for merely seeking the maximum point of intermediate frequency signal level, the signal receiver reflecting the second preferred embodiment of the present invention not only correctly receives the desired channel signal using the significantly improved performance characteristics, but it also securely suppresses error generated by the tuning circuit even when respective tuning elements function with erroneous components.

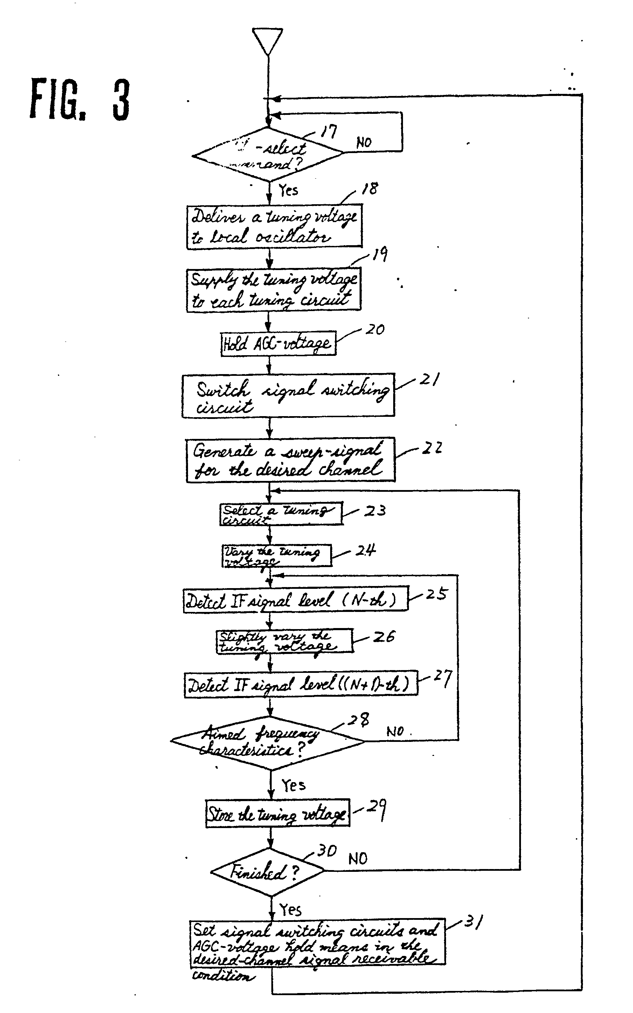

FIG. 3 represents the chart describing the sequential procedure needed for controlling tuning operation related to the first preferred embodiment using control means 9. While R-circuit 1 operates for receiving the desired channel signal, the system remains in identifying routine 17, where the system stands by for receiving channel (Ch)-select command from channel-select command means 10. When changing the desired-channel signal, i.e.,

when changing it to another channel, channel-select command means outputs the binary-coded channel control signal. After detecting this signal in the identifying routine 17, as shown in routine 18, control means 9 delivers a specific tuning voltage corresponding to the desired channel to local oscillator 16 of R-circuit 1. When routine 19 is entered, control means provides input tuning circuit 12 and interstage tuning circuit 14 with tuning voltages having specific potentials identical to the tuning voltage fed to said local oscillator 16. This allows R-circuit 1 to receive the desired channel, and thus, mixer 15 outputs intermediate frequency signals. This signal then passes through signal switching circuit 4 before being demodulated by intermediate-frequency amplifier/demodulator 6. Said amplifier/demodulator 6 then delivers a specific AGC voltage corresponding to the desired channel signal level to AGC-voltage hold means 5. When routine 20 is entered, AGC voltage is retained so that gain of radio-frequency amplifier 13 and the output level of sweep-signal generating means 2 can be held constant. This activated routine 21, in which signal-switching circuit 3 is switched to sweep-signal generating means 2, and likewise, signal switching circuit 4 is switched to intermediate-frequency signal level detection means 8. When routine 22 is entered, tuning-voltage delivery means 7 delivers a specific tuning voltage to allow sweep-signal generating means 2 to sweep frequencies within the desired channel frequency band.

This activates routine 23, in which either the input tuning circuit 12 or the interstage tuning circuit 14 is selected. For example, the system selects input tuning circuit 12 before proceeding to routine 24. When routine 24 is entered, only the tuning voltage delivered to input tuning circuit 12 is varied to a level close to the lowest frequency within the desired channel frequencies. When routine 25 is entered, intermediate-frequency signal level detection means 8 detects the signal levels of plural frequencies in the desired channel frequency band from the intermediate frequency signals corresponding to these frequencies. When routine 26 is entered, only the tuning voltage delivered to input tuning circuit 2 is slightly varied before detecting signal levels by applying procedure identical to that is executed during routine 25.

By designating data of signal levels detected during routine 25 to be the N-th data of signal levels detected during routine 26 to be the N+1th data, routine 28 identifies whether the aimed frequency characteristics are achieved, or not. If the aimed frequency characteristics were achieved, routine 29 is entered. conversely, if these characteristics were not yet realized, system operation is again back to routine 25 to be followed by routines 26 and 27 before proceeding to routine 28 over again. When routine 29 is entered, control means 9 stores the binary-coded tuning voltage data fed to input tuning circuit 12 in memory to complete provision of tuning voltage for input tuning circuit 12. However, since interstage tuning circuit 14 still needs to be provided with the tuning voltage, operation mode returns to routine 23 from routine 30, by applying the selected tuning circuit to be one of tuning circuits of interstage tuning circuit 14, operation mode again sequentially proceeds to routines 24 through 29. In the same way, after control means 9 fully stores data related to tuning voltages in memory, operation mode proceeds from identifying routine 30 to routine 31, in which signal switching circuits 3 and 4 and AGC-voltage hold means 5 are respectively provided with the desired-channel signal receivable condition so that they can respectively receive desired-channel signals. This causes the operation mode to be back to routine 17, and as a result, control means 9 causes the system to follow up stand-by mode until the next channel-selection command is generated.

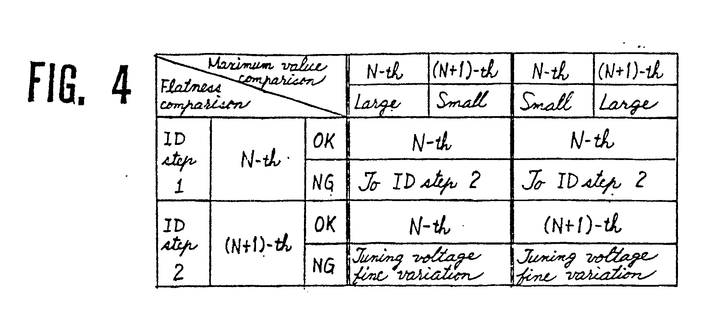

FIG. 4 represents the chart related to one of preferred embodiments of designating the identification basis when executing identifying routine 28 of tuning control means shown in FIG. 3. The N-th and N+1th data detected by routines 25 and 26 are delivered to control means 9, which then checks to see the maximum values compared between respective center frequencies present in the desired-channel frequency bands and the flatness of more than two units of frequencies. In particular, since the flatness of frequency characteristics present in R-circuit 1 precedes the maximum value, independent of the magnitude of the maximum values of the N-th and N+1th data, if the N-th data proves to be flat, the system introduces the N-th data. Conversely, if the N-th data proves to degrade the flatness of frequency characteristics, identification (ID) step 2 is entered, in which only when the N+1th data proves to ensure flatness of frequency characteristics, the system introduces either of the N-th and N-1th data whichever designates the maximum value. However, while said identification step 2 is still underway, if N+1th data proves that no flatness is achieved for frequency characteristics, both the N-th and N+1th data are identified to be defective for use, and then, the system proceeds to further routines so that tuning voltage is subjected to fine variations furthermore.

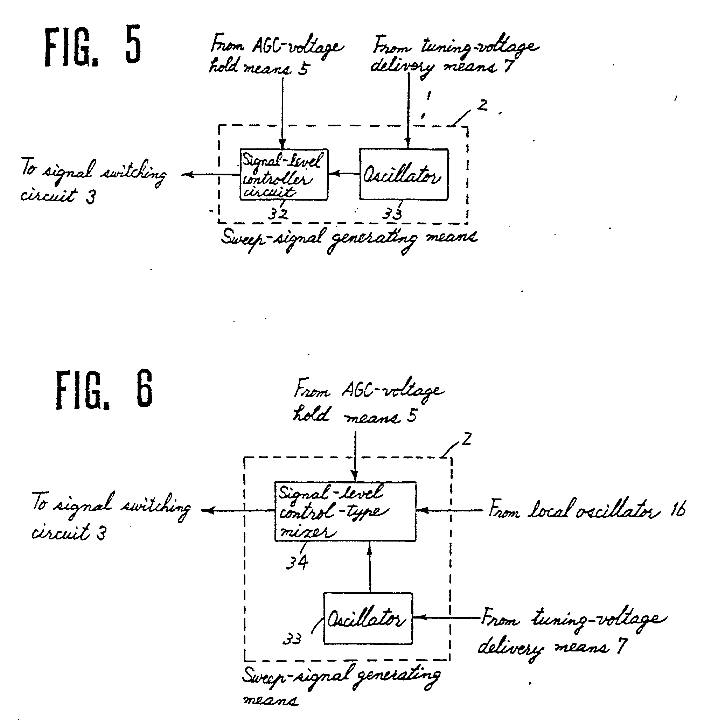

FIGs 5 through 11 respectively denote typical embodiments of the present invention in conjunction with sweep-signal generating means of the signal receiver.

Sweep-signal generating means shown in FIG. 5 is comprised of primary oscillator 33 and signal-level controller circuit 32. Tuning voltage delivery means 7 delivers a specific tuning voltage to sweep-signal generating means so that oscillator 33 can securely oscillates itself within the desired-channel frequency band to correctly sweep frequencies. Signal oscillated by oscillator 33 is delivered to said signal-level controller circuit 32. AGC-voltage hold means 5 feeds AGC voltage to said signal-level controller circuit 32 so that the delivered signals can be set to the predetermined level corresponding to the AGC voltage before eventually being delivered to signal-switching circuit 3 as the reference signal. Using the system shown in FIG. 5, reference signal can easily be generated.

FIG. 6 represents another preferred embodiment of sweep-signal generating means of the signal receiver related to the present invention, which is comprised of the primary oscillator 33 and signal-level control-type mixer 34. Tuning voltage delivery means 7 delivers a specific tuning voltage so that said oscillator 33 can oscillates itself within a specific frequency band corresponding to either the intermediate frequency band or the sum of the oscillated frequency generated by local oscillator 16 and the desired channel frequency, while signal oscillated by the primary oscillator 33 and part of signal oscillated by local oscillator 16 are respectively delivered to signal-level control type mixer 34. AGC-voltage hold means 5 feeds a specific AGC voltage to said signal-level control type mixer 34, which is then set to a specific signal level corresponding to the level of AGC voltage before being delivered to signal-switching circuit 3 as the reference signal. By introducing the system shown in FIG. 6, intermediate frequency signal can be made available either for the stationary frequency or sweeping frequency, and yet, it is possible for the system to freely make up the constitution of intermediate-frequency signal level detection means.

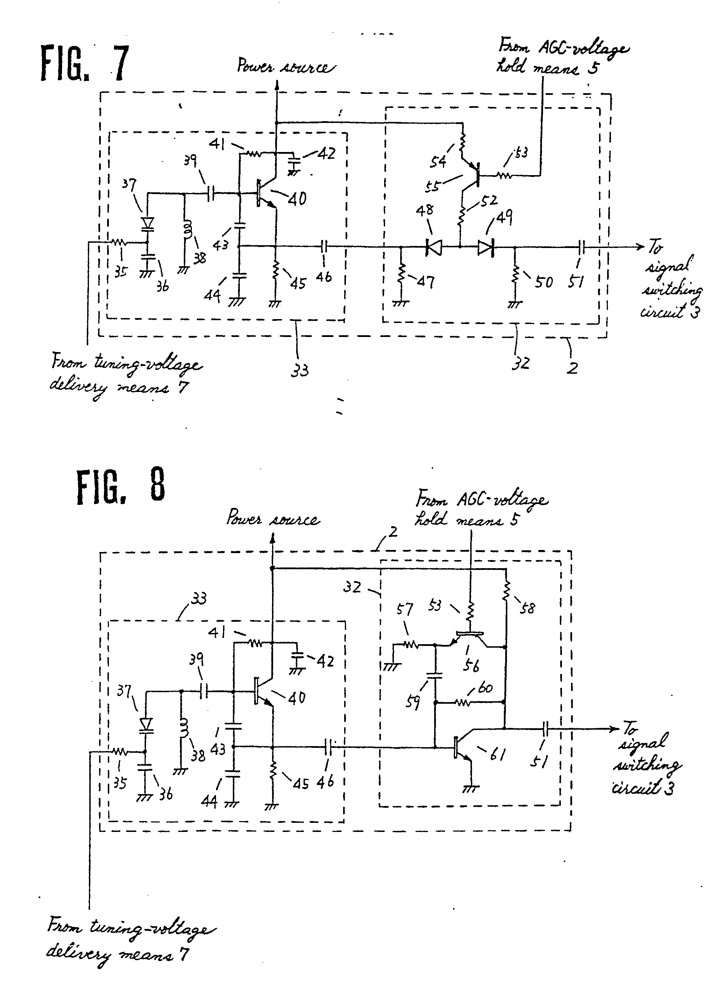

Primary oscillator 33 shown in FIG. 7 is provided with varactor diode 37 that makes up tank circuit in the base electrode of transistor 40 via capacitor 39 and parallel resonance circuit made of coil 38, which are respectively connected to each other between grounds. Cathode of varactor diode 37 is grounded by capacitor 36, while tuning voltage delivery means 7 feeds a specific tuning voltage oscillated in the desired-channel frequency band to the cathode-capacitor connected point via resistor 35. Capacitors 43 and 44 are substantially feedback capacitors, oscillating frequency is determined by varactor diode 37, capacitors 43, 44 and 39, and coil 38. Resistors 41 and 45 respectively bias said transistor 40, while collector electrode of this transistor is grounded via capacitor 42. Oscillated signals are fed to cathode of diode 48 of signal-level controller circuit 32 via DC-blocking capacitor 46. Anodes of diodes 48 and 49 are connected to each other, while the oscillated signals from cathode of diode 49 is delivered to signal-switching circuit 3 via capacitor 51. Collector electrode of transistor 55 is connected to the connection point of anodes of diodes 48 and 49 via resistor 52, whereas base electrode of said transistor 55 is provided with AGC voltage which is delivered from AGC-voltage hold means 5 via resistor 54. Emitter electrode of said transistor 55 is connected to power-supply source via resistor 54. Cathodes of diodes 48 and 49 are respectively grounded via resistors 47 and 50. In response to the AGC voltage from AGC-voltage hold means 5, current flowing through collector of transistor 55 varies to cause the insertion loss of said diodes 48 and 49 to also vary, and as a result, level of the oscillated signal delivered to said signal-switching circuit 3 also varies. The system shown in FIG. 7 features simple circuit constitution and effectively functions when oscillator 33 oscillates high-level signals.

Primary oscillator shown in FIG. 8 has the constitution and functions exactly identical to those which are explained in the above description related to FIG. 7, and therefore, detailed description is deleted. Oscillated signal is first delivered to signal-level controller circuit 32 via capacitor 46, which is then fed to base electrode of transistor 61. Emitter electrode of transistor 61 is grounded, whereas biasing resistor 60 is connected between base-and-collector electrodes and resistor 58 between collector electrode and power-supply source, respectively. Collector electrode of transistor 61 is connected to collector electrode of transistor 56. Emitter electrode of transistor 56 is grounded via resistor 57. AGC-voltage hold means 5 feeds AGC voltage to base electrode of transistor 56 via resistor 53. When AGC voltage rises, collector potential of transistor 56 lowers, and at the same time, bias voltage of transistor 61 also lowers to lower gain, and eventually causes the level of oscillated signal to lower before delivery to signal-switching circuit 3. When the AGC voltage is high, gain of radio-frequency amplifier 13 also rises to lower the level of oscillated signal. conversely, when the AGC voltage is low, gain of radio-frequency amplifier 13 is also low, thus high-level oscillated signal is fed. This level is proportional to the signal level of desired channel. The system described above uses transistor which is provided with amplifying function, thus making it possible for the system to lower the level of signal oscillated by said oscillator 33, which in turn usefully serves for preventing unnecessary radiation and spurious jamming as well.

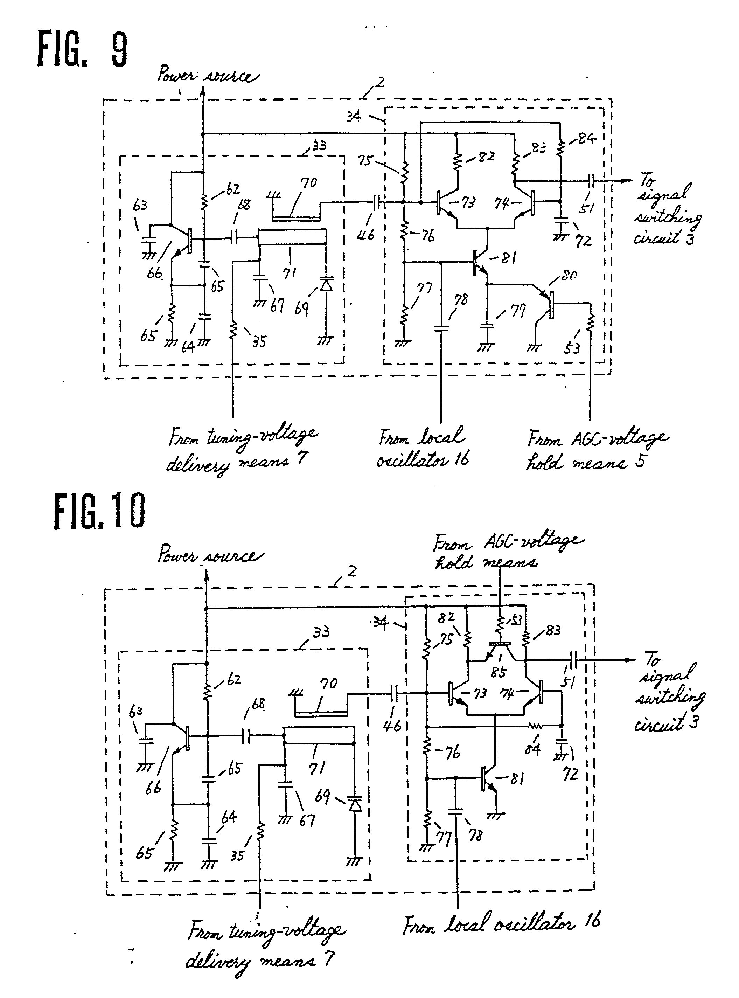

Primary oscillator 33 shown in FIG. 9 oscillates at a specific frequency band higher than those which are oscillated by oscillators shown in FIGs 7 and 8. Base electrode of transistor 66 is connected to resonance circuit comprised of capacitor 67, tuning line 71, and varactor diode 69 between grounds via capacitor 68. Tuning-voltage delivery means 7 delivers a specific tuning voltage to the contact point of capacitors 67 and 68 and tuning line 71 via resistor 35, in which said tuning voltage oscillates either in the intermediate frequency band or in a specific frequency band corresponding to the sum of the oscillated frequency of local oscillator 16 and the desired-channel frequency. Capacitors 64 and 65 are substantially feedback capacitors. Resistors 62 and 65 respectively bias transistor 66, while collector electrode of this transistor is grounded via capacitor 63. Oscillated signal is fed to line 70 from tuning line 71 by means of magnetic-field coupling and then delivered to base electrode of transistor 73 of signal-level control-type mixer 34 via DC block capacitor 46. Emitter electrodes of transistors 73 and 74 are connected to each other, whose contact point is connected to collector electrode of transistor 81. On the other hand, emitter electrode of transistor 81 is connected to emitter electrode of transistor 80, while collector electrode of transistor 80 is grounded. AGC-voltage hold means 5 delivers AGC voltage to base electrode of transistor 80 via resistor 53 to allow emitter current corresponding to AGC voltage to flow into transistor 81 via transistor 80. Local oscillator 16 delivers part of signal oscillated by itself to base electrode of transistor 81 via DC-blocking capacitor 78. Base electrode of transistor 74 is grounded via capacitor 72. Oscillated signal delivered to base electrode of said transistor 73 and part of signal oscillated by local oscillator 16 fed to base electrode of said transistor 81 are respectively mixed together in transistors 73 and 74, which then generate signals corresponding to the desired-channel frequency band. These signals are then delivered from collector electrode of said transistor 74 to signal-switching circuit 3 via DC-blocking capacitor 51. Since current flowing through emitters of transistors 80 and 81 is varied by AGC voltage, current flowing through emitters of said transistors 73 and 74 also varies, thus eventually varying the conversion gain of said mixer 34. As a result, when AGC voltage is high, emitter current lowers, thus causing the conversion gain of mixer 34 to lower, and consequently, level of reference signal lowers itself before delivery to signal-switching circuit 3. Conversely, when AGC voltage is low, level of reference signal rises, thus making it possible for the system to generate signal which is proportional to the level of desired channel signal. Resistors 75 through 77 and 82 through 84 are respectively biasing resistors, while capacitor 79 is used for grounding high frequencies since the system shown above uses equilibrium-type signal-level controlling mixer 34, it effectively suppresses spurious jamming (disturbance).

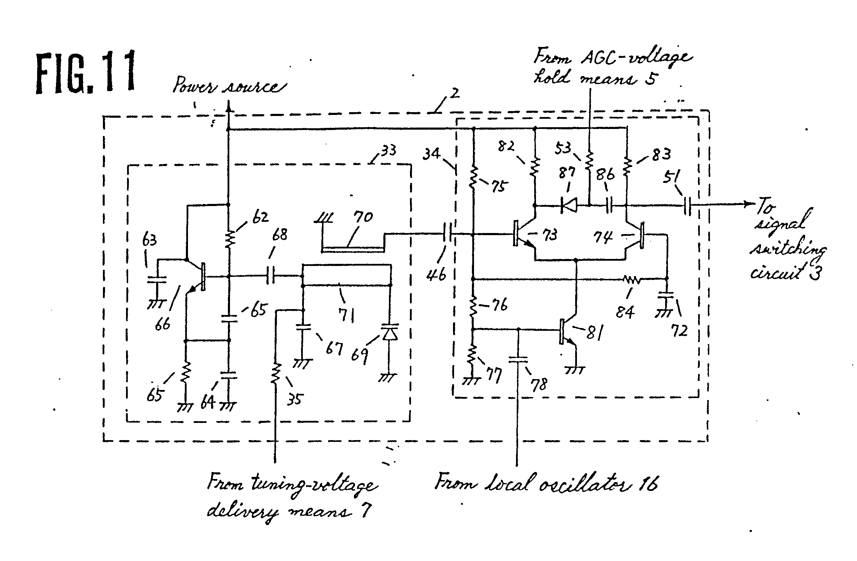

See FIG. 10. Since the primary oscillator 33 performs operations exactly identical to those which have been described in reference to FIG. 9, detailed explanation is deleted. Signal oscillated by primary oscillator 33 is delivered to base electrode of transistor 74 of signal-level control-type mixer 34 from line 70 via DC-blocking capacitor 46. Emitter electrodes of transistors 73 and 74 are connected to each other, while collector electrode of transistor 81 is connected to the contact point of these emitter electrodes. Emitter electrode of transistor 81 is grounded, while said emitter electrode is connected to emitter/collector electrodes of transistor 85 between collector electrodes of transistors 73 and 74. AGC-voltage hold means 5 feeds AGC voltage to base electrode of transistor 85 via resistor 53 so that potentials of emitter and collector of said transistor 85 and collectors of said transistors 73 and 74 can vary in response to the delivered AGC voltage. On the other hand, local oscillator 16 feeds part of signal oscillated by itself to base electrode of said transistor 81 via capacitor 78. Base electrode of said transistor 74 grounds radio-frequency components via capacitor 72. Signal oscillated by primary oscillator 33 delivered to base electrode of said transistor 73 and part of signal oscillated by local oscillator 16 fed to base electrode of said transistors 81 are mixed together by said transistors 73 and 74 before generating a specific signal corresponding to the desired-channel frequency band. This signal is then delivered to signal-switching circuit 3 from collector electrode of said transistor 74 via DC-blocking capacitor 51. Since potentials of emitter and collector of transistor 85 are varied by AGC voltage, collector potentials of said transistors 73 and 74 also vary themselves, and eventually varying the conversion gain of mixer 34. As a result, when the AGC voltage is high, collector potential of transistor 74 lowers as the voltage between base and emitter of said transistor 85 more significantly biases itself in the forward direction, thus causing the conversion gain of said mixer 34 to lower. Consequently, level of reference signal lowers before being delivered to signal-switching circuit 3. Conversely, when AGC voltage is low, the reference signal level rises, thus making it possible for the system to generate signal which is proportional to the desired-channel signal level. Resistors 75 through 77 and 81 through 84 are respectively biasing resistors. Since the system shown above uses signal-level controlling balanced 34, it effectively suppresses spurious jamming (disturbance).

See FIG. 11. Since the primary oscillator 33 performs operations exactly identical to those which have been described in reference to FIG. 9, detailed explanation is deleted. Signal oscillated by primary oscillator 33 is delivered to base electrode of transistor 73 of signal-level control-type mixer 34 from line 70 via DC-blocking capacitor 46. Emitter electrodes of transistors 73 and 74 are connected to each other, while collector electrode of transistor 81 is connected to the contact point of these emitter electrodes. Emitter electrode of said transistor 81 is grounded, while collector electrode of transistor 73 is connected to cathode of diode 87. Capacitor 86 is connected between anode of said diode 87 and collector electrode of said transistor 84. AGC voltage hold means 5 delivers AGC voltage to anode of said diode 87 via resistor 53 to cause anode potential of said diode 87 to vary in response to AGC voltage received. On the other hand, local oscillator 16 delivers part of signal oscillated by itself to base electrode of said transistor 81 via DC-blocking capacitor 78. Base electrode of said transistor 74 grounds high-frequency components. Signal oscillated by primary oscillator 33 and fed to base electrode of said transistor 73 and part of signal oscillated by local oscillator 16 fed to base electrode of said transistor 81 is mixed together by said transistors 73 and 74. As a result, signal corresponding to the desired-channel frequency band is generated, which is then delivered to signal-switching circuit 3 from collector electrode of said transistor 74 via DC-blocking capacitor 51. When using the system shown in FIG. 11, as the AGC voltage rises, said diode 87 more significantly biases in the forward direction to lower loss of signal flowing through said diode 87. This allows signals of the desired-channel frequency band present in collector electrode of transistor 74 generated by mixing operation to cancel with each other, thus eventually lowering the level of reference signal before being delivered to signal-switching circuit 3. Conversely, when AGC voltage is low, level of reference signal rises, thus allowing the system to generate signal which is proportional to the desired-channel signal level. Resistors 75 through 77 and 82 through 84 are respectively biasing resistors. Since the system shown in FIG. 11 uses signal-level controlling balanced 34, it effectively suppresses spurious jamming (distortion).

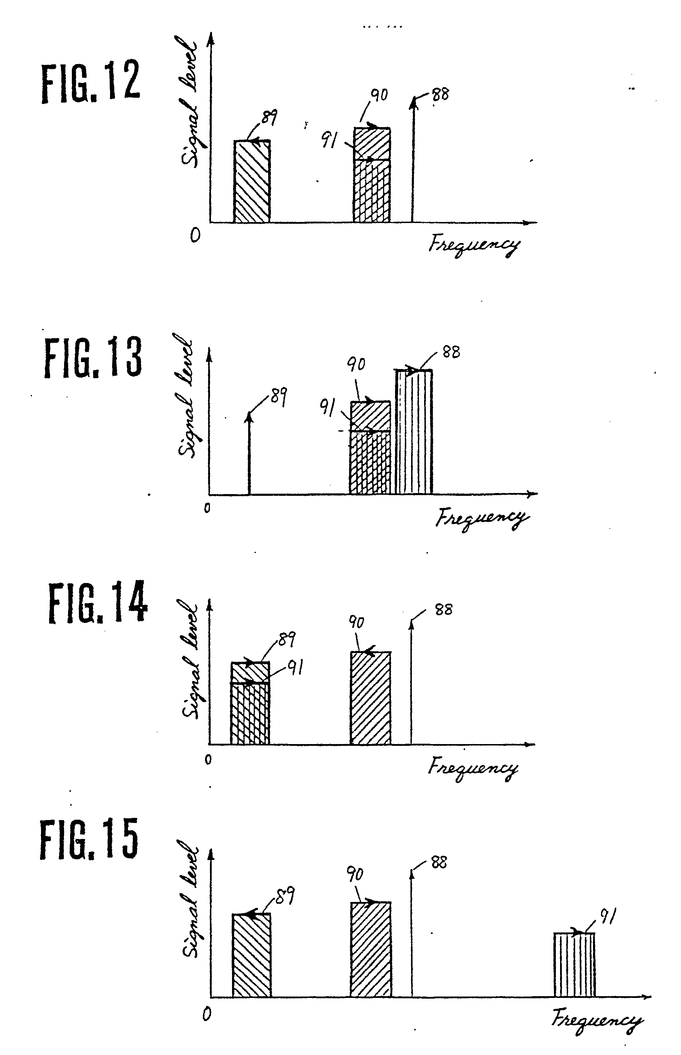

FIGs 12 and 13 and respectively the charts denoting the relationship of frequencies used for sweep-signal generating means 2 of the first preferred embodiment related to the present invention.

Referring now to FIG. 12, signal 89 denotes intermediate frequency signal output from R-circuit 1. Signal 90 denotes reference signal output from said sweep-signal generating means 2. Signal 91 denotes signal oscillated by primary oscillator 33, whereas signal 88 denotes signal oscillated by local oscillator 16.

Primary oscillator 33 oscillates signals by sweeping frequencies within the desired-channel frequency band. Oscillated signal level is first controlled by applying AGC voltage before being made available for reference signal. Since local oscillator 16 of R-circuit 1 oscillates itself using a stationary frequency, signal containing swept frequency appears in the intermediate-frequency band. Width and velocity of the frequency-swept signal are identical to those of signals oscillated by primary oscillator 33, however, frequency is swept in the inverse direction. The frequency relationship shown in FIG. 12 suggests that no spurious disturbance can take place because oscillation is directly applied to signals in the desired-channel frequency band.

See FIG. 13. Since the chart refers to signals 88 through 91 which are shown in FIG. 12, detailed description is deleted.

Primary oscillator 33 oscillates signals by sweeping frequencies within the desired-channel frequency band. The level of oscillated signals is first controlled by applying AGC voltage before these signal are made available for reference signals. Since local oscillator 16 of R-circuit 1 oscillates itself by sweeping frequencies, signal containing a stationary frequency appears in the intermediate frequency band. Signal oscillated by local oscillator 16 has the same width, velocity, and direction of swept frequency as those of signals oscillated by primary oscillator 33. The frequency relationship shown in FIG. 13 suggests that no spurious disturbance can take place because oscillation is directly applied to signals in the desired-channel frequency band.

Furthermore, since the intermediate-frequency signal contains a stationary frequency, intermediate-frequency signal-level detection means 8 can easily be made up, thus providing another advantage for the system.

FIGs 14 through 17 are respectively the charts denoting the frequency relationship related to sweep-signal generating means 2 making up the second preferred embodiment of the signal receiver reflecting the present invention.

In FIG. 14, signal 88 denotes the signal oscillated by local oscillator 16. Signal 89 denotes the intermediate-frequency signal output from R-circuit 1. Signal 90 denotes the reference signal output from sweep-signal generating means 2, whereas signal 91 denotes the signal oscillated by primary oscillator 33.

Primary oscillator 33 oscillates itself by sweeping frequencies within intermediate frequency band. Local oscillator 16 of R-circuit 1 oscillates itself by applying a stationary frequency. Signals oscillated by both oscillators are then mixed together by sweep-signal generating means 2. The system uses reference signal which is substantially comprised of the differential signal of applied frequencies. As a result, R-circuit 1 outputs a specific intermediate-frequency signal containing swept frequencies. Said intermediate-frequency signal has the same width, velocity, and direction of the swept frequency as those of signals oscillated by primary oscillator 33.

The system mentioned above allows optional frequencies within the desired-channel band of intermediate frequency band to be replaced by frequencies to be oscillated by primary oscillator 33, thus effectively eliminating the needs for identifying respective frequencies made available for intermediate frequency additionally.

See FIG. 15. Since the chart refers to signals 89 through 91 which are shown in FIG. 14, detailed explanation is deleted. Primary oscillator 33 oscillates itself by sweeping frequencies of a specific frequency band corresponding to the sum of the desired-channel frequency and the frequency oscillated by local oscillator 16. Local oscillator 16 of R-circuit 1 oscillates itself by applying a stationary frequency. Both of the oscillated signals are mixed together by sweep-signal generating means 2. The system uses reference signal which is substantially comprised of the differential signal of applied frequencies. As a result, R-circuit 1 outputs a specific intermediate-frequency signal containing swept frequencies. Said intermediate-frequency signal has the same width, velocity, and direction of the swept frequency as those of signals oscillated by primary oscillator 33. However, frequency is swept in the direction opposite from the direction of the frequency-oscillation of oscillator 33.

In this frequency relationship shown in FIG. 15, the system allows optional frequencies within the desired-channel band of intermediate frequency band to be replaced by frequencies to be oscillated by primary oscillator 33. In addition, since the system shown in FIG. 15 raises frequencies to be oscillated by primary oscillator 33. This allows the fractional band width to be narrowed, thus making it possible for the system to make up said oscillator 33 easily.

See FIG. 16. since the chart refers to signals 88 through 91 which are shown in FIG. 14, detailed explanation is deleted.

Primary oscillator 33 oscillates itself by applying a stationary frequency of a specific intermediate-frequency band. Local oscillator 16 of R-circuit 1 oscillates itself by sweeping frequencies. Both of the oscillated signals are mixed together by sweep-signal generating means 2. The system sues reference signal which is substantially comprised of the differential signal of applied frequencies. As a result, R-circuit 1 outputs a specific intermediate-frequency signal containing swept frequencies. Width, velocity, and direction of the swept frequency of the signal oscillated by local oscillator 16 and the reference signal are identical to each other.

In the frequency relationship shown in FIG. 16, since primary oscillator 33 oscillates itself by applying a stationary frequency and generates reference signal by causing local oscillator 16 used for channel selection to sweep frequencies, there is no need of synchronizing signals oscillated by primary oscillator 33 and local oscillator 16. In addition, since stationary frequencies are used for intermediate-frequency signals, sweep-singal generating means 2 and intermediate-frequency signal-level detection means 8 can easily be made up.

See FIG. 17. Since the chart refers to signals 88 through 91 which are shown in FIG. 14, detailed explanation is deleted.

Primary oscillator 33 oscillates itself by applying a stationary frequency of a specific frequency band corresponding to the sum of the desired-channel frequency and the frequency oscillated by local oscillator 16, whereas local oscillator 16 of R-circuit 1 oscillates itself by sweeping frequencies. Both of the oscillated signals are mixed together by sweep-signal generating means 2. Differential frequency signal is made available for reference signal. As a result, R-circuit 1 outputs intermediate-frequency signals containing swept frequencies. Width and velocity of swept frequencies of signals oscillated by local oscillator 16 and the reference signal are identical to each other except for the inversed sweeping direction. Width and velocity of swept frequencies of intermediate-frequency signal doubles those of the reference signal, while the sweeping direction is opposite from each other.

In the frequency relationship shown in FIG. 17, primary oscillator 33 oscillates itself by applying a stationary frequency and generates reference signal by causing local oscillator 16 used for channel selection to sweep frequencies. This eliminates the needs for synchronizing signals oscillated by primary oscillator 33 and local oscillator 16, and as a result, sweep-signal generating means 2 can easily be made up. In addition, since the width of swept frequency of intermediate-frequency signal is widened twice, frequency resolution of intermediate-frequency signal-level detection means 8 is significantly improved.

FIGs 18 through 26 are respectively the schematic diagrams denoting typically preferred embodiments of intermediate-frequency signal-level detection means 8 of the signal receiver related to the present invention.

In FIG. 18, a specific intermediate-frequency signal generated by frequency-converted reference signal is first extracted from signal-switching circuit 4 for delivery to sampling filter 93, which then filters out only a specific signal containing the aimed frequency. This signal is then delivered to detector 94, which is then converted into a specific DC voltage corresponding to the intermediate-frequency signal level. This voltage is then delivered to A/D converter 92 before being converted into binary-coded signals that can be processed by control means 9.

When the aimed frequency is generated, control means 9 delivers control signal to A/D converter 92 so that analogue signal can be converted into digitally encoded signal. Since the circuit shown in FIG. 18 detects the signal level when the aimed frequency is reached by controlling A/D converter 92, circuit reflecting this embodiment features simplified constitution compared to the mechanism for switching sampling filter.

FIG. 19 is the schematic block diagram of intermediate-frequency signal-level detection means 8 used for realizing the frequency-relationship explained in the preceding FIGs 12, 14, 15 and 17. Sampling filter 93 is comprised of a plurality of frequency-fixed type filters 95 compatible with the aimed frequencies connected to each other in parallel, which sequentially filter out the aimed frequencies. Filtered frequencies are delivered to detector 94, which are then converted into a specific DC voltage corresponding to the needed signal level. Said DC voltage is then delivered to A/D converter 92 before being converted into binary-coded signals that can be processed by control means 9.

When the aimed frequencies are reached, control means 9 feeds control signal to A/D converter 92 for executing analogue-digital conversion of signals. Since the circuit shown in FIG. 19 detects signal level when the aimed frequencies are reached by controlling A/D converter without switching sampling filter, the circuit featuring simple constitution can easily be made.

FIG. 20 is the schematic block diagram of the circuit of intermediate-frequency signal-level detection means 8 used for realizing the frequency-relationship explained in conjunction with FIGs 13 and 16. Sampling filter 93 is comprised of frequency-fixed type filter 96 that samples signal of the fixed frequencies. Filtered frequencies are then delivered to detector 94, which then converts these frequencies into a specific DC voltage corresponding to the needed signal level. Said DC voltage is then delivered to A/D converter 92 and then converted into binary-coded signal that can be processed by control means 9. When reference-signal frequency reaches the aimed frequency number, control means 9 delivers control signal to A/D converter 92 for executing analogue-digital conversion of signals. Since the circuit shown in FIG. 20 detects signal level when the aimed frequency number is reached by controlling A/D converter, the circuit featuring simple constitution can easily be made up compared to the mechanism for switching sampling filter. Furthermore, since sampling filter is substantially comprised of a frequency-fixed type filter, the entire circuit is significantly simplified.

FIG. 21 is the schematic block diagram of the circuit of intermediate-frequency signal-level detection means 8 used for realizing the frequency-relationship explained in conjunction with FIGs 12 through 17. Sampling filter 93 is comprised of a plurality of frequency-variable type filters 97 compatible with the aimed frequencies, which sequentially sample signals containing the aimed frequencies. Filtered sample signals are then delivered to detector 94, which are then converted into a specific DC voltage corresponding to the needed signal level before being delivered to A/D converter which converts the received signal into binary-coded signals that can be processed by control means 9.

When the aimed frequency is reached, control means 9 delivers control signal to A/D converter 92 for executing analogue-digital conversion of signals. Since the circuit shown in FIG. 21 detects signal level when the reference signal is exactly at the aimed frequency by controlling A/D converter, the circuit featuring simple constitution can easily be made up compared to the mechanism for switching sampling filter. Furthermore, since sampling filter 93 is substantially comprised of a frequency-variable filter, even if intermediate-frequency signal uses either a fixed frequency or swept frequency, exactly identical circuit can be constituted.

FIG. 22 is the schematic block diagram of the circuit of intermediate-frequency signal-level detection means 8 explained in conjunction with FIG. 19. Sampling filter 93 is comprised of a plurality of SAW filters 95, which are respectively provided with characteristic for filtering out only the aimed plural frequencies.

Signal-switching circuit 4 delivers a specific intermediate-frequency signal to intermediate-frequency signal-level detection means 8. This signal is then led to sampling filter 93, which then filters out a specific intermediate-frequency signal corresponding to the aimed plural frequencies of reference signal. filtered signal is then delivered to detector 94, in which intermediate-frequency signal rectified by diodes 100 and 101 is converted into a specific DC voltage by capacitor 102 and resistor 98. The DC-converted signal is then converted into binary-coded signal corresponding to said DC voltage by A/D converter 92 before eventually being delivered to control means 9. The aimed frequency is internally detected by said control means 9 which feeds a specific tuning voltage to sweep-signal generating means 2 that generates reference signal. When the aimed frequency is reached, control means 9 feeds control signal to A/D converter 92, which then receives a specific DC voltage corresponding to intermediate-frequency signal level for converting it into binary-coded signals. The circuit shown in FIG. 22 detects signal level when the aimed frequency is reached by controlling A/D converter without switching sampling filter, thus making it possible for the entire system to make up significantly simplified circuit constitution.

FIG. 23 is the schematic block diagram of the circuit of intermediate-frequency signal-level detection means 8 explained in conjunction with the circuit shown in FIG. 20. Sampling filter 93 is comprised of a SAW filter 96 which is provided with characteristic for filtering out the stationary frequency of intermediate-frequency band. Signal-switching circuit 4 delivers a specific intermediate-frequency signal containing a stationary frequency to sampling filter 93 of intermediate-frequency signal-level detection means 8. Sampling filter 93 filters out all the intermediate-frequency signals compatible with the reference signal containing the aimed plural frequencies. Filtered signal is then delivered to detector 94, where intermediate-frequency signal rectified by diodes 100 and 101 is converted in DC voltage by capacitor 102 and resistor 98. The DC-converted signal is further converted into binary-coded signal corresponding to DC voltage by means of A/D converter 92 before eventually being delivered to control means 9. The aimed frequency is internally detected by said control means 9 which feeds tuning signal to sweep-signal generating means 2 generating the reference signal. When the aimed frequency is reached, control means 9 delivers control signal to A/D converter 92, which then converts the received DC voltage matching intermediate-frequency signal level into binary-coded signal. Since the circuit shown in FIG. 23 uses a sampling filter and detects a specific signal level when the aimed frequency is reached by controlling A/D converter, the entire circuit constitution can be simplified significantly.

FIG. 24 is the schematic block diagram of the circuit of intermediate-frequency signal-level detection means 8 explained in conjunction with the circuit shown in FIG. 21. Sampling filter 93 is comprised of frequency-variable filter 97 which makes up the turning circuit using coil 104 and varactor diode 105 used for tuning operation. Said frequency-variable filter 97 feeds a specific tuning voltage to cathode of varactor diode 105 before filtering out signals containing the aimed frequency. Filtered signal is then delivered to detector 94, where intermediate-frequency signal rectified by diodes 100 and 101 is converted into DC voltage by capacitor 102 and resistor 98. The DC-converted signal is further converted into binary-coded signal corresponding to DC voltage by means of A/D converter 92 before eventually being delivered to control means 9. The aimed frequency of the reference signal is internally detected by said control means 9 which feeds tuning signal to sweep-signal generating means 2 generating the reference signal. When the aimed frequency is reached, control means 9 delivers control signal to A/D converter 92, which then converts the received DC voltage matching intermediate-frequency signal level into binary-coded signal. Since the circuit shown in FIG. 24 detects signal level when the reference signal gains access to the aimed frequency by controlling A/D converter 92, the entire circuit can be significantly simplified compared to the mechanism for switching sampling filter itself. In addition, since sampling filter 93 is substantially frequency-variable filter 97, even if the intermediate-frequency signal uses either a stationary frequency or the swept frequency, the circuit itself can be made up using the identical constitution.

FIG. 25 is the schematic block diagram of the circuit of intermediate-frequency signal-level detection means 8 used for realizing the frequency-relationship explained in the preceding FIGs 12 through 17. A/D converter 107 first converts intermediate-frequency signal output from signal-switching circuit 4 into binary-coded signals. Digital filter 108 samples only a specific frequency of intermediate frequency band corresponding to the aimed frequency of the reference signal for delivery to control means 9. The circuit shown in FIG. 25 uses digital filter for sampling signals containing the aimed frequency, and thus, it is possible for the entire circuit system to introduce semiconductors, and in addition, the aimed frequency can be changed without modifying the circuit constitution.

FIG. 26 is the schematic block diagram of the circuit of intermediate-frequency signal-level detection means 8 used for realizing the frequency-relationship explained in the preceding FIGs 12 through 17. When signal-switching circuit 4 outputs intermediate-frequency signal, CCD filter 109 first receives control signal from control means 9 and then samples a specific frequency from intermediate-frequency band corresponding to the aimed frequency of the reference signal. When A/D converter 107 identifies that the aimed frequency is reached, it receives control signal from control means 9 and converts the sampled signal into binary-coded signal for delivery to control means 9. The circuit shown in FIG. 26 uses CCD filter for sampling the aimed-frequency signal, and thus, it is possible for the system to introduce semiconductors, and in addition, the aimed frequency can be changed without modifying the circuit constitution.

FIGs 27 and 28 are respectively the schematic block diagrams of the circuits of tuning-voltage delivery means of the signal receiver reflecting other preferred embodiments of the present invention.

See FIG. 27. Tuning-voltage delivery means functions as follows. First, control means 9 delivers control signal that causes register 112 to remain in the hold condition and the binary-coded signal related to tuning voltage. The control signal causes register 112 to hold said binary-coded signal related to tuning voltage. When this signal is delivered to D/A converter 111 while register 112 is still in the hold condition, the system generates a specific tuning voltage that correctly matches the binary-coded signals in order that the tuning voltage can be delivered to base electrode of transistor 114 and then to the tuning circuit via resister 116 by causing transistor 114 to function as emitter follower. A circuit 117 which is comprised of register 112, D/A converter 111, and transistor 114, is connected to each tuning circuit. Each circuit causes register 112 to hold binary-coded signals related to tuning voltage in order that these signals can effectively be activated for individually supplying tuning voltages. The reference numeral 110 shown in FIG. 27 denotes the power-supply terminal, whereas the reference numerals 113 and 115 respectively denote bias resistors. The circuit shown in FIG. 27 is provided with a register for each tuning circuit, and as a result, once the binary-coded signal is held by register 112, tuning voltage remains constant until changing it in the following process. The circuit constitution shown in FIG. 27 is ideally suited for fully introducing semiconductor means.

Next, operations of the circuit of tuning-voltage delivery means shown in FIG. 28 are described below. Control means 9 first delivers the control signal turning transistor 120 ON and OFF and the binary-coded tuning voltage to register 112, while causing register 112 to hold the binary-coded tuning voltage data. When this data is delivered to D/A converter 111 while said hold-condition is present, tuning voltage that matches the binary-coded signal is generated, which is then delivered to base electrode of transistor 114. This causes emitter electrodes of transistors 114 and 120 to be connected to each other and capacitor 119 to be also connected between collector electrode and ground of transistor 120. Capacitor 119 is charged while transistor 120 is ON, while it retains the charged voltage while transistor 120 is OFF. As a result, this voltage is supplied to the tuning circuit via resistor 116 as the tuning voltage. A circuit 118 comprised of transistor 120 and capacitor 119 is connected to each tuning circuit. The binary-coded tuning-voltage data is then delivered to register 112, which is then converted into a specific DC voltage by D/A converter 111, and then said DC voltage charges capacitor 119 by provisionally activating transistor 120 of circuit 118 connected to the tuning circuit which needs a specific tuning voltage corresponding to the DC voltage converted by D/A converter 111. After a specific tuning voltage is delivered to respective tuning circuits, the tuning voltage is again delivered to respective tuning circuits based on the discharge constant shorter than that of capacitor 119 so that tuning voltage can be prevented from incurring variation. The reference numerals 113, 115 and 121 respectively denote bias resistors. The circuit shown in FIG. 28 allows a specific tuning voltage to be sequentially supplied to respective tuning circuits. As a result, once the tuning voltage is securely held by register means, variation of tuning voltage remains minimum until the tuning voltage is changed next. In addition, since the circuit shown in FIG. 28 uses each one unit of register and D/A converter which respectively need a number of component elements, and yet, since each tuning circuit uses each one unit of transistor and capacitor to make up extremely simplified constitution, the circuit constitution shown in FIG. 28 is ideally suited for fully introducing semiconductor means.

FIGs 29 and 30 are respectively the schematic block diagram of the signal-switching circuit 3 of the signal receiver, denoting preferred embodiments of the present invention. In the circuit diagram shown in FIG. 29, the desired-channel signal is received from input terminal 11, which is then delivered to anode of diode 124 via DC-blocking capacitor 123. On the other hand, the reference signal from sweep-signal generating means 2 is delivered to anode of diode 122 via DC-blocking capacitor 131. Bias current is delivered to diode 124 via resistor 132 and choke-coils 126 and 127. Resistor 128 is connected to the connection point of choke coil 127 and resistor 132 and to base electrode of transistor 129. Collector electrode of transistor 129 is connected to anode of diode 122 via choke coil 130. Cathodes of diodes 122 and 124 are respectively connected to each other, while choke coil 126 is connected between the contact point of both cathodes and ground. Said contact point is also connected to R-circuit 1 via DC-blocking capacitor 125. Thus, when control means 9 feeds control voltage that turns transistor OFF, diode 124 becomes connective and diode 122 disconnected, allowing the desired-channel signal from terminal 11 to be fed to R-circuit 1. Conversely, when control means 9 delivers control signal that activates transistor 129, diode 122 becomes connective and diode 124 disconnected, thus allowing sweep-signal generating means 2 to deliver reference signal to R-circuit 1 to implement switching of signals. The system shown in FIG. 29 features simplified circuit constitution that effectively switches signals using only two units of diodes.

Next, operations of the circuit shown in FIG. 30 are described below. The desired-channel signal is received from terminal 11, which is then delivered to base electrode of transistor 138 via DC-blocking capacitor 123. On the other hand, sweep-signal generating means 2 delivers reference signal to base electrode of transistor 137 via DC-blocking capacitor 131. Emitter electrodes of transistors 137 and 138 are connected to each other, while the connected point of these electrodes remains in contact with collector electrode of transistor 141. Constant bias current is delivered to transistor 141 via constant-voltage-regulated power-supply source 143 and bias resistors 142 and 143, thus making up a constant-current circuit. On the other hand, control means 9 feeds control signal to base electrode of transistor 137 via resistor 139. Control signal from control means 9 is also fed to base electrode of transistor 133 via resistor 140, while collector electrode of transistor 133 is connected to base electrode of transistor 138. Collector electrode of said transistor 133 is also connected to power-supply source via resistor 134. collector electrode cf transistor 141 is connected to R-circuit 1 via DC-blocking capacitor 125. Consequently, when control means 9 delivers control voltage to turn transistor 133 OFF, collector potential of said transistor 133 rises to turn transistor 138 ON and transistor 137 OFF, thus allowing the desired-channel signal from terminal 11 to be delivered to R-circuit 1. Conversely, when control means 9 delivers control voltage that activated transistor 129, transistor 138 turns OFF and transistor 137 ON, thus allowing the reference signal from sweep-signal generating means 2 to be delivered to signal R-circuit 1 so that signal switching can be implemented. Since the circuit system shown in FIG. 30 merely uses transistors and resistors to make up the entire constitution, this system is ideally suited for fully introducing semiconductor means to make up an integrated circuit.

FIGs 31 and 32 are respectively the schematic block diagrams of the signal-switching circuit of the signal receiver, reflecting preferred embodiments of the present invention. See FIG. 31. Intermediate-frequency signals from R-circuit 1 are first delivered to cathode of diode 122 via DC-blocking capacitor 125. Anode of diode 124 is connected to intermediate-frequency amplifier/demodulator 6 via DC-blocking capacitor 123, whereas anode of diode 122 is connected to intermediate-frequency signal-level detection means 8 via DC-blocking capacitor 131. Diode 124 receives bias current from resistor 132 and choke-coils 126 and 127. Resistor 128 is connected to the connection point between choke-coil 127 and resistor 132 and also to base electrode of transistor 129. Collector electrode of transistor 129 is connected to anode of diode 122 via choke coil 130. Cathodes of diodes 122 and 124 are connected to each other, while choke coil 126 is connected to the connection point of these cathodes and between grounds. Consequently, when control means 9 delivers control signal that turns transistor 129 OFF, diode 124 becomes connective and diode 122 disconnected, thus allowing intermediate-frequency signal from R-circuit 1 to be delivered to intermediate-frequency amplifier/demodulator 6 via DC-blocking capacitor 123. conversely, when control means 9 delivers control signal that activates transistor 129, diode 122 becomes connective and diode 124 disconnected. This allow intermediate-frequency signal from R-circuit 1 to be delivered to intermediate-frequency signal-level detection means 8 via DC-blocking capacitor 131 so that signal switching can be implemented. The circuit system shown in FIG. 31 executes switching of signals by applying only two units of diodes, thus featuring extremely simplified constitution.

See FIG. 32. Intermediate-frequency signal from receiver 1 is first delivered to base electrode of transistor 141 via DC-blocking capacitor 145. Collector electrode of transistor 138 is connected to intermediate-frequency amplifier/demodulator 6 via DC-blocking capacitor 146. On the other hand, collector electrode of transistor 137 is connected to intermediate-frequency signal-level detection means 8 via DC-blocking capacitor 147. Emitter electrodes of said transistors 137 and 138 are connected to each other. The connection point of these emitter electrodes is connected to collector electrode of transistor 141 which receives constant bias current from ccnstant-voltage-regulated power-supply source 143 and bias resistor 144, thus making up a constant-current circuit. On the other hand, control means 9 delivers control signal to base electrode of transistor 137 via resistor 139, while control signal from control means 9 is also delivered to base electrode of transistor 133 via resistor 140. Collector electrode of transistor 133 is connected to base electrode of transistor 138. Collector electrode of transistor 133 is connected to power-supply source via resistor 134. On the other hand, collector electrode of transistor 141 is connected to R-circuit 1 via DC-blocking capacitor 125. Consequently, when control means 9 outputs control voltage that turns transistor 133 OFF, collector potential rises to turn transistor 138 ON and transistor 137 OFF, thus allowing intermediate-frequency signal from R-circuit 1 to be delivered to intermediate-frequency amplifier/demodulator 6 via DC-blocking capacitor 146. Conversely, when control means 9 delivers control voltage activating transistor 129, transistor 138 turns OFF and transistor 137 ON to allow intermediate-frequency signal from R-circuit 1 to be delivered to intermediate-frequency signal-level detection means 8 via DC-blocking capacitor 147 so that signal switching operation can eventually be implemented. The circuit system shown in FIG. 32 merely uses transistors and resistors to make up the entire constitution, and thus, this circuit system is ideally suited for implementing an integrated circuit by fully introducing semiconductor means.

FIGs 33 and 34 are respectively the schematic block diagrams of AGC-voltage hold means of the signal receiver reflecting still further preferred embodiments of the present invention. See FIG. 33. AGC voltage output from intermediate-frequency amplifier/demodulator 6 is first delivered to emitter electrode of transistor 153 which turns ON and OFF on receipt of control signal from control means 9. While receiving the desired-channel signal, transistor 153 remains activated. This transistor however remains OFF until tuning voltages are eventually set after completing delivery of channel-select signal from channel-select means to control means 9. While transistor 153 is ON, capacitor 151 is charged with a specific DC voltage proportional to the AGC voltage. When transistor 153 is OFF, AGC-voltage hold means holds the voltage immediately before transistor 153 turns OFF. Capacitor 151 delivers its voltage to base electrode of transistor 148, while this voltage is also delivered to radio-frequency amplifier 13 and sweep-signal generating means 2 via resistor 149 from emitter electrode of said transistor 148 acting as the emitter-follower. Consequently, while transistor is ON, AGC voltage which is varied by control signal from control means 9 is delivered to radio-frequency amplifier 13 and sweep-signal generating means 2. When transistor 153 is OFF, AGC-voltage hold means holds a specific AGC voltage which was present immediately before transistor 153 turns OFF. This allows the system to feed constant voltage to radio-frequency amplifier 13 and sweep-signal generating means 2. The circuit system shown in FIG. 33 securely holds a specific AGC voltage using two transistors and a capacitor, thus greatly helps promote simplification of the circuit constitution.

See FIG. 34. A specific AGC voltage output from intermediate-frequency amplifier/demodulator 6 is first converted into binary-coded signal by A/D converter 156, which is then delivered to register 155 to securely maintain the status inside of register 155. Thus, when holding the AGC voltage constant, the content of said register 155 is retained. Data signal output from register 155 is converted into an analogue voltage by D/A converter 154, which is then delivered to radio-frequency amplifier 13 and sweep-signal generating means 2. The circuit system shown in FIG. 34 uses register means that holds the binary-coded AGC voltage data. This circuit effectively prevents the retained AGC-voltage from varying itself due to varying environmental conditions.

FIG. 35 is the simplified block diagram of control means of the signal receiver reflecting preferred embodiments of the present invention. The tuning control procedure for operating the signal receiver related to the present invention is converted into binary-coded data, which is stored in a non-volatile memory 164. All the system elements function in accordance with these data related to the established tuning control procedure. The binary-coded channel-control signal output from channel-select command means 10 is delivered to data-receiving register (1) 159 through input-buffering gate 157. On the other hand, in accordance with the tuning control procedure, operation circuit 163 first reads the content of data-receiving register (1) 159 and then delivers the binary-coded tuning voltage data signal to signal-output register (2) 162, which then outputs this data signal to local oscillator 16, input tuning circuit 12 and interstage tuning circuit 14 via output-buffer gate 158. The tuning voltage data delivered to these circuits is stored in volatile memory 165. Next, control means delivers binary-coded control signal to signal-output register (1) 161. This controls AGC-voltage hold means 5 for retaining AGC voltage constant. Control means then delivers binary-coded control signal to signal-output register (1) 161 for switching signal-switching circuits 3 and 4. Then, control means delivers tuning voltage to signal-output register (2) 162 for delivery to sweep-signal generating means 2. Control means also delivers control signal to signal-output register (1) 161 for controlling sweep-signal generating means 2. These signals from control means are respectively delivered to sweep-signal generating means 2 via output-buffer gate 158. Selection of respective tuning circuits, delivery and fine variation of the tuning voltage are executed in the same manner as described above.

Next, intermediate-frequency signal output from R-circuit 1 is converted into binary-coded signals by intermediate-frequency signal-level detection means 8 before being delivered to signal-input register (2) 160 via input-buffer gate 157. Operation circuit 163 then compares the binary-coded intermediate-frequency signal to the aimed frequency characteristics and then varies the tuning voltage so that the best frequency characteristics can be generated by executing sequential operations identical to those which are described above. When the optimum frequency characteristics are achieved, control means causes non-volatile memory 164 to store the data related to the tuning voltage delivered to respective tuning circuits. Control means then sets signal-switching circuits 3 and 4 and AGC-voltage hold means 5 to the status of correctly receiving the desired-channel signal.

The circuit system shown in FIG. 35 easily varies the tuning control procedure merely by changing the content of non-volatile memory. The circuit system shown here is ideally suited for making up an integrated circuit by fully introducing semiconductor means.

FIG. 36 is the simplified block diagram of the entire circuit of the signal receiver, denoting the third preferred embodiment of the present invention. Terminal 116 receives those signals which are in a specific frequency band different from those channel band delivered to terminal 11. Signal-switching circuits 3 and 167, input-tuning circuits 12 and 168, radio-frequency amplifiers 13 and 169, interstage tuning circuits 14 and 170, and mixers 15 and 171, are respectively provided with identical constitution. Using signals oscillated by local oscillator 16, the desired-channel signal from terminal 11 is converted into intermediate-frequency signal by mixer 15. Likewise, using signals oscillated by the oscillator of sweep-signal generating means 2, the desired-channel signal from terminal 116 is converted into intermediate-frequency signal by mixer 171.

Consequently, when receiving the desired-channel signal from terminal 11, local oscillator 16 is made available for selecting the desired channel. Conversely, when receiving the desired-channel signal from terminal 116, oscillator of sweep-signal generating means 2 is used so that it functions as the local oscillator itself, whereas local oscillator 16 itself is made available for the oscillator of sweep-signal generating means 2. The circuit constitution denoting the third preferred embodiment of the present invention shown in FIG. 36 eliminates the needs for providing an additional oscillator generating reference signal needed for controlling the tuning voltage of the receiver unit receiving signal of a plurality of frequency bands. In addition, since a local oscillator which is not used for channel-selection is made available, compared to the circuit of the second preferred embodiment, the circuit constitution shown in FIG. 36 can be significantly simplified.

## Claims

**1.** A signal receiver apparatus comprising:

a receiver part (1) for converting a radio frequency signal to an intermediate frequency signal, comprising at least one tuning circuit (12, 14) for tuning a frequency of said radio frequency signal, a radio frequency amplifier (13) for amplifying said radio frequency signal, a local oscillator (16) for generating a local oscillation signal, and a mixer (15) for mixing the frequency-tuned radio frequency signal and said local oscillation signal to obtain said intermediate frequency signal;

demodulating means (6) for demodulating said intermediate frequency signal;

reference signal generating means (2) for generating a reference signal;

means (3) for applying said reference signal to said receiver part as said radio frequency signal;

voltage delivery means (7) for delivering voltages to said tuning circuit to change a frequency characteristic of said receiver part;

detecting means (8) for detecting levels of a frequency signal derived from said receiver part corresponding to a plurality of frequencies within a predetermined frequency range to obtain a frequency characteristic of said receiver part; and

control means (9) for converting said voltages supplied by said voltage delivery means and said levels into binary-coded signals which are stored in memory and for performing a frequency characteristic adjusting operation of said apparatus by controlling said reference signal generating means and said local oscillator to sweep a frequency of a signal to be processed in said receiver part within said predetermined frequency range so that the frequency characteristic of said receiver part appears as a response of said frequency signal derived from said receiver part of the frequency-swept signal, comparing the frequency characteristic of said receiver part obtained by said detecting means with a desired frequency characteristic to obtain an error therebetween, and controlling said voltage delivery means to change the frequency characteristic of said receiver part to reduce said error until said error is substantially eliminated,

characterised in that said detecting means (8) detects levels of said intermediate frequency signal corresponding to a plurality of frequencies within said predetermined frequency range to obtain the frequency characteristic of said receiver part,

that said control means (9) controls said reference signal generating means (2) and said local oscillator (6) through said voltage delivery means (7) to sweep the frequency of one of said reference signal and said local oscillation signal within said predetermined frequency range and maintain constant the frequency of the other of said reference signal and said local oscillation signal, and

that said apparatus further comprises AGC voltage holding means (5) for holding an AGC voltage obtained at said demodulating means (6) when a selected channel signal is received and applying the held AGC voltage signal to said radio frequency amplifier (13) to fix a gain of said radio frequency amplifier and to said reference signal generating means (2) to fix a level of said reference signal at substantially the same level as said selected channel signal during the frequency characteristic adjusting operation.

**2.** An apparatus according to claim 1, wherein said reference signal generating means (2) has an oscillator (33) whose oscillation frequency is controlled by a voltage supplied from said voltage delivery means (7) within a frequency band of said selected channel signal.

**3.** An apparatus according to claim 1, wherein said reference signal generating means (2) comprises an oscillator (33) for generating an oscillation signal whose frequency is controlled by a voltage supplied from said voltage delivery means (7), and a mixer (34) for mixing said oscillation signal and said local oscillation signal to obtain said reference signal.

**4.** An apparatus according to claim 3, wherein said oscillator (33) in said reference signal generating means (2) oscillates within a frequency band of said intermediate frequency signal.

**5.** An apparatus according to claim 3, wherein said oscillator (33) in said reference signal generating means (2) oscillates within a sum of a frequency band of said intermediate frequency signal and the frequency of said local oscillation signal.

## Revendications

**1.** Appareil récepteur de signaux comportant:

une partie de récepteur (1 ) destinée à convertir un signal de radiofréquence en un signal de fréquence intermédiaire , comprenant au moins un circuit d'accord (12,14) pour accorder une fréquence dudit signal de radiofréquence, un amplificateur de radiofréquence (13) pour amplifier ledit signal de radiofréquence, un oscillateur local (16) pour produire un signal d'oscillation locale et un mélangeur (15) pour mélanger le signal de radiofréquence accordé en fréquences et ledit signal d'oscillation locale afin d'obtenir ledit signal de fréquence intermédiaire ;

un dispositif de démodulation (6) destiné à démoduler ledit signal de fréquence intermédiaire ;

un dispositif générateur de signal de référence (2) destiné à produire un signal de référence ;

un dispositif (3) destiné à appliquer ledit signal de référence à ladite partie de réception comme ledit signal de radiofréquence ;

un dispositif de fourniture de tension (7) destiné à délivrer des tensions audit circuit d'accord pour changer la caractéristique en fréquences de ladite partie de récepteur ;

un dispositif de détection (8) destiné à détecter des niveaux d'un signal de fréquences dérivé de ladite partie de récepteur, correspondant à plusieurs des fréquences dans une plage de fréquences prédéterminée afin d'obtenir une caractéristique en fréquences de ladite partie de récepteur ; et

un dispositif de commande (9) destiné à convertir lesdites tensions fournies par ledit dispositif de fourniture de tensions et lesdits niveaux en des signaux de code binaire qui sont mémorisés dans une mémoire et pour effectuer une opération de réglage de caractéristique en fréquences dudit appareil en commandant ledit dispositif générateur de signal de référence et ledit oscillateur local afin de balayer une fréquence d'un signal à traiter dans ladite partie du récepteur à l'intérieur de ladite plage de fréquences prédéterminée de manière que la caractéristique en fréquences de ladite partie de récepteur apparaisse comme une réponse audit signal de fréquences dérivé par ladite partie de récepteur du signal de balayage en fréquences, comparant la caractéristique en fréquences de ladite partie de récepteur obtenue par ledit dispositif de détection avec une caractéristique en fréquences voulue afin d'obtenir une erreur entre eux, et en commandant ledit dispositif de fourniture de tension pour changer la caractéristique en fréquences de la partie de récepteur afin de réduire ladite erreur jusqu'à ce que ladite erreur soit pratique ment éliminée,

caractérisé en ce que ledit dispositif de détection (8) détecte les niveaux dudit signal de fréquence intermédiaire correspondant à plusieurs des fréquences dans ladite plage de fréquences prédéterminées pour obtenir la caractéristique en fréquences de ladite partie de récepteur,
en ce que ledit dispositif de commande (9) commande ledit dispositif générateur de signal de référence (2) et ledit oscillateur local (6) par l'intermédiaire dudit dispositif de fourniture de tension (7) pour balayer la fréquence de l'un dudit signal de référence et dudit signal d'oscillation locale dans ladite plage de fréquences prédéterminée pour maintenir constante la fréquence de l'autre signal de référence et dudit signal d'oscillateur local, et
en ce que ledit appareil comporte en outre un dispositif de maintien de tension AGC (5) pour maintenir une tension AGC obtenue audit dispositif de démodulation (6) lorsqu'un signal de canal sélectionné est reçu et pour appliquer le signal de tension AGC maintenu audit amplificateur à radiofréquence (13) pour fixer le gain dudit amplificateur de radiofréquence et audit dispositif générateur de signal de référence (2) pour fixer le niveau dudit signal de référence, pratiquement au même niveau que ledit signal de canal sélectionné pendant l'opération de réglage des caractéristiques en fréquences.

2. Appareil selon la revendication 1, dans lequel ledit dispositif générateur de signal de référence (2) comporte un oscillateur (33) dont la fréquence d'oscillation est commandée par une tension fournie par ledit dispositif de fourniture de tension (7) dans une bande de fréquences dudit signal de canal sélectionné.

3. Appareil selon la revendication 1, dans lequel ledit dispositif générateur de signal de référence (2) comporte un oscillateur (33) qui produit un signal d'oscillation dont la fréquence est commandée par une tension fournie par ledit dispositif de fourniture de tension (7) et un mélangeur (34) destiné à mélanger ledit signal d'oscillation et ledit signal d'oscillation locale pour obtenir ledit signal de référence.

4. Appareil selon la revendication 3, dans lequel ledit oscillateur (33) dudit dispositif générateur de signal de référence (2) oscille dans une bande de fréquences dudit signal de fréquence intermédiaire

5. Appareil selon la revendication 3, dans lequel ledit oscillateur (33) dudit dispositif générateur de signal de référence (2) oscille dans une somme de la bande de fréquences dudit signal de fréquence intermédiaire et la fréquence dudit signal d'oscillation locale.

## Ansprüche

1. Signalempfangsgerät
mit einem Empfängerteil (1) zur Umwandlung eines Funkfrequenzsignals in ein Zwischenfrequenzsignal, der mindestens einen Abstimmkreis (12,14) zur Abstimmung auf eine Frequenz des Funkfrequenzsignals, einen Funkfrequenz-Verstärker (13) zur Verstärkung des Funkfrequenzsignals, einen lokalen Oszillator (16) zur Erzeugung eines örtlichen Schwingungssignals und einen Mischer (15) zum Mischen des auf eine Frequenz abgestimmten Funkfrequenzsignals und des örtlichen Schwingungssignals enthält, um das Zwischenfrequenzsignal zu erhalten,
mit einem Demodulator (6) zum Demodulieren des Zwischenfrequenzsignals,
mit einem Bezugssignal-Generator (2) zur Erzeugung eines Bezugssignals,
mit einem Hilfsmittel (3) zur Anlegung des Bezugssignals an den Empfängerteil als Funkfrequenzsignal,
mit einer Spannungszuführ-Vorrichtung (7) zur Zuleitung von Spannungen an den Abstimmkreis, um eine Frequenzeigenschaft des Empfängerteils abzuändern,
mit einem Detektor (8) zur Wahrnehmung der Größen eines Frequenzsignals, das entsprechend mehreren Frequenzen innerhalb eines vorherbestimmten Frequenzbereiches aus dem Empfängerteil abgeleitet ist, um eine Frequenzeigenschaft des Empfängerteils zu erhalten, und
mit einer Steuerung (9) zur Umwandlung der von der Spannungszuführ-Vorrichtung gelieferten Spannungen und der Größe des Frequenzsignals in binärcodierte Signale, die in einem Speicher abgelegt werden, und zur Einstellung der Frequenzeigenschaft des Gerätes durch eine Steuerung des Bezugssignal-Generators und des lokalen Oszillators, um eine Frequenz eines im Empfängerteil zu bearbeitenden Signals innerhalb des vorherbestimmten Frequenzbereiches zu suchen, so daß die Frequenzeigenschaft des Empfängerteils als Reaktion auf das Frequenzsignal erscheint, das aus dem Empfängerteil des Signals bei der gesuchten Frequenz abgeleitet ist, wobei die Frequenzeigenschaft des Empfängerteils,die von dem Detektor erhalten wird, mit einer erwünschten Frequenzeigenschaft zwecks Ermittlung eines Fehlers verglichen und die Spannungszuführ-Vorrichtung so gesteuert wird, daß sich die Frequenzeigenschaft des Empfängerteils ändert, um den Fehler so weit zu vermindern, bis er im wesentlichen ausgeschaltet ist,
dadurch gekennzeichnet, daß der Detektor (8) die Größe des Zwischenfrequenzsignals entsprechend mehreren Frequenzen innerhalb des vorherbe stimmten Frequenzbereiches wahrnimmt, um die Frequenzeigenschaft des Empfängerteils zu erhalten,
daß die Steuerung (9) über die Spannungszuführ-Vorrichtung (7) den Bezugssignal-Generator (2) und den lokalen Oszillator (16) derart steuert, daß die Frequenz eines Bezugssignals und das örtliche Schwingungssignal innerhalb des vorherbestimmten Frequenzbereiches gesucht und die Frequenz des anderen Bezugssignals und das örtliche Schwingungssignal konstant gehalten werden, und
daß das Gerät ferner eine Haltevorrichtung (5) für eine AGC-Spannung enthält, um diese am Demodulator (6) erhaltene AGC-Spannung festzuhalten, wenn ein Signal eines gewählten Kanals empfangen wird, und um das Signal der festgehaltenen AGC-Spannung dem Funkfrequenz-Verstärker (13) zum Festsetzen seines Verstärkungsgrades und dem Bezugssignal-Generator (2) zum Festsetzen einer Größe des Bezugssignals auf im wesentlichen derselben Größe wie die des Signals des gewählten Kanals während des Einstellvorgangs der Frequenzeigenschaft zuzuführen.

2. Gerät gemäß Anspruch 1, bei dem der Bezugssignal-Generator (2) einen Oszillator (33) aufweist, dessen Schwingungsfrequenz von einer von der Spannungszuführ-Vorrichtung (7) gelieferten Spannung innerhalb eines Frequenzbandes des Signals des gewählten Kanals gesteuert wird.

3. Gerät nach Anspruch 1, bei dem der Bezugssignal-Generator (2) einen Oszillator (33) zur Erzeugung eines Schwingungssignals, dessen Frequenz von einer Spannung gesteuert wird, die von der Spannungszuführ-Vorrichtung (7) geliefert wird, und einen Mischer (34) zum Mischen des Schwingungssignals und des örtlichen Schwingungssignals enthält, um das Bezugssignal zu erhalten.

4. Gerät gemäß Anspruch 3, bei dem der Oszillator (33) des Bezugssignal-Generators (2) innerhalb eines Frequenzbandes des Zwischenfrequenzsignals schwingt.

5. Gerät gemäß Anspruch 3, bei dem der Oszillator (33) des Bezugssignal-Generators (2) innerhalb einer Summe aus einem Frequenzband des Zwischenfrequenzsignals und aus der Frequenz des örtlichen Schwingungssignals schwingt.

FIG. 1
Signal switching circuit
Input tuning circuit
Radio-frequency amplifier
Interstage tuning circuit
mixer
Receiving (R-) circuit
Local oscillator
Signal switching circuit
AGC-voltage hold means
IF amplifier/demodulator
Tuning-voltage delivery means
IF signal level detection means
Sweep-signal generating means
Channel-select control means
Ch.-select command means
1
2
3
4
5
6
7
8
9
10
11
12
13
14
15
16

FIG. 2
11
3
Signal switching circuit
12
Input tuning circuit
13
Radio-frequency amplifier
14
Interstage tuning circuit
15
Mixer
1
Receiving (R-) circuit
16
Local oscillator
4
Signal switching circuit
5
AGC-voltage hold means
6
IF amplifier/demodulator
8
IF signal level detection means
7
Tuning-voltage delivery means
2
Sweep-signal generating means
9
Channel-select control means
10
Ch.-select command means

FIG. 3

17
NO
Yes
18
Delivers a tuning voltage to local oscillator
19
Supply the tuning voltage to each tuning circuit
20
Hold AGC-voltage
21
Switch signal switching circuit
22
Generate a sweep-signal for the desired channel
23
Select a tuning circuit
24
Vary the tuning voltage
25
Detect IF signal level (N-th)
26
Slightly vary the tuning voltage
27
Detect IF signal level ((N+1)-th)
28
Aimed frequency characteristics?
NO
Yes
29
Store the tuning voltage
30
NO
Finished?
Yes
31
Set signal switching circuits and AGC-voltage hold means in the desired-channel signal receivable condition

FIG. 4

| Flatness comparison \ Maximum value comparison | | | N-th | (N+1)-th | N-th | (N+1)-th |
|---|---|---|---|---|---|---|
| | | | Large | Small | Small | Large |
| ID step 1 | N-th | OK | N-th | | N-th | |
| | | NG | To ID step 2 | | To ID step 2 | |
| ID step 2 | (N+1)-th | OK | N-th | | (N+1)-th | |
| | | NG | Tuning voltage fine variation | | Tuning voltage fine variation | |

FIG. 5

From AGC-voltage hold means 5
From tuning-voltage delivery means 7
2
To signal switching circuit 3
Signal-level controller circuit
Oscillator
32
33
Sweep-signal generating means

FIG. 6

From AGC-voltage hold means 5
2
To signal switching circuit 3
Signal-level control-type mixer
From local oscillator 16
34
Oscillator
33
From tuning-voltage delivery means 7
Sweep-signal generating means

FIG. 7
Power source
From AGC-voltage hold means 5
41
42
39
37
40
54
53
55
52
48
49
43
35
36
38
44
45
46
47
50
51
To signal switching circuit 3
From tuning-voltage delivery means 7
33
32
2

FIG. 8
Power source
From AGC-voltage hold means 5
2
32
33
57
53
58
41
42
56
39
37
40
59
60
43
61
51
35
36
38
44
45
46
To signal switching circuit 3
From tuning-voltage delivery means 7

FIG. 9

Power source
2
34
33
75
82
83
84
62
70
63
68
46
73
74
To signal switching circuit 3
51
76
72
66
71
81
65
67
69
77
78
79
80
65
64
35
53
From tuning-voltage delivery means 7
From local oscillator 16
From AGC-voltage hold means 5

FIG.10

From AGC-voltage hold means
Power source
2
34
82
53
83
33
75
85
51
To signal switching circuit 3
62
70
73
74
68
46
63
84
76
72
65
71
81
66
69
64
67
65
35
77
78
From tuning-voltage delivery means 7
From local oscillator 16

To signal switching circuit 3
From AGC-voltage hold means 5
From local oscillator 16
From tuning-voltage delivery means 7
Power source


FIG. 11

FIG. 12
Signal level
89
91
90
88
0
Frequency

FIG. 13
Signal level
89
91
90
88
0
Frequency

FIG. 14
Signal level
89
91
90
88
0
Frequency

FIG. 15
Signal level
89
90
88
91
0
Frequency

FIG. 16

Signal level
91
89
90
88
0
Frequency

FIG. 17

Signal level
89
92
88
91
0
Frequency

FIG. 18
From signal switching circuit 4
IF signal-level detection means
8
Sampling filter
93
92
A/D converter
Detector
94
To control means 9
From control means 9
FIG. 19
From signal switching circuit 4
Sampling filter
95
95
95
8
Frequency-fixed type filter
Frequency-fixed type filter
Frequency-fixed type filter
93
92
A/D converter
Detector
94
To control means 9
IF signal-level detection means
From control means 9

FIG. 20

From signal switching circuit 4
8
IF signal-level detection means
96
Frequency-fixed type filter
93
92
A/D converter
Detector
94
To control means 9
From control means 9

FIG. 21

From signal switching circuit 4
97
8
IF signal-level detection means
Frequency-variable type filter
93
92
A/D converter
Detector
94
To control means 9
From control means 9

FIG. 22

8
IF signal-level detection means
Sampling filter
93
95
95
95
94
92
99
100
A/D converter
To control means 9
From signal switching circuit 4
101
102
98
Detector
From control means 9

FIG. 23

IF signal-level detection means
8
94
92
93
Detector
Sampling filter
99
A/D converter
From signal switching circuit 4
To control means 9
100
96
101
102
98
From control means 9

FIG. 24
IF signal-level detection means
8
93
94
92
97
100
105
99
101
102
98
104
106
103
A/D converter
From signal switching circuit 4
To control means 9
From control means 9
From tuning voltage delivery means 7
FIG. 25
IF signal-level detection means
8
107
108
A/D converter
Digital filter
From signal switching circuit 4
To control means 9
From control means 9

FIG. 26
IF signal-level detection means
8
109
107
CCD filter
A/D converter
From signal switching circuit 4
To control means 9
From control means 9

FIG. 27

110
117
116
114
115
113
D/A converter
111
Register
112
7
Tuning-voltage delivery means
117 117 117 117
From control means 9

FIG. 28

110
7
116
118
Tuning-voltage delivery means
119
120
121
115
114
113
D/A converter
111
Register
112
From control means 9

FIG. 29

Signal switching circuit
123
124
135
To receiving (R-) circuit 1
11
127
126
3
122
130
131
129
132
128
From control means 9
Power source
From sweep-signal generating means 2

FIG. 30

Signal switching circuit
Power source
133
134
135
136
3
138
137
11
123
125
142
141
To receiving (R-) circuit 1
140
143
144
139
131
From control means 9
From sweep-signal generating means 2

# FIG. 31

Signal switching circuit
To IF amplifier/ demodulator 6
From receiving (R-) circuit 1
124
125
123
126
127
4
122
130
131
129
128
132
From control means 9
Power source
To IF signal level detection means 8

# FIG. 32

Signal switching circuit
Power source
4
133
134
135
136
146
To IF amplifier/ demodulator 6
To IF signal level detection means 8
138
137
147
140
From receiving (R-) circuit 1
141
145
143
144
139

FIG. 33

Power source
AGC-voltage hold means
5
148
153
149
From IF amplifier/demodulator 6
To radio-frequency amplifier 13 and sweep-signal generating means 2
150
151
152
From control means 9

FIG. 34

AGC-voltage hold means
5
To radio-frequency amplifier 13 and sweep-signal generating means 2
D/A converter
Register
A/D converter
From IF amplifier/demodulator 6
154
155
156
From control means 9

FIG. 35
To AGC-voltage hold means 5
To signal switching circuits 3, 4
To tuning-voltage delivery means 7
From channel-select command means 10
From IF signal level detection means 8
157
157
158
158
158
158
158
9
Data-receiving register 1
Data-receiving register 2
Signal-output register 1
Signal-output register 2
159
160
161
162
163
164
165
Operation circuit
Non-volatile memory
Volatile memory
Channel-select control means

FIG. 36
Signal switching circuit
Input tuning circuit
Radio-frequency amplifier
Interstage tuning circuit
mixer
Local oscillator
Receiving (R-) circuit
Signal switching circuit
AGC-voltage hold means
IF amplifier/demodulator
IF signal level detection means
Tuning-voltage delivery means
Channel-select control means
Ch.-select command means
Sweep-signal generating means
1
2
3
4
5
6
7
8
9
10
11
12
13
14
15
16
166
167
168
169
170
171